(19) Europäisches Patentamt
European Patent Office
Office européen des brevets

(11) **EP 4 660 667 B1**

(12) **EUROPEAN PATENT SPECIFICATION**

(45) Date of publication and mention
of the grant of the patent:
**05.08.2026 Bulletin 2026/32**

(21) Application number: **24382621.1**

(22) Date of filing: **07.06.2024**

(51) International Patent Classification (IPC):
$H03M\ 5/06^{(2006.01)}$    $H04B\ 1/7073^{(2011.01)}$
$H04J\ 13/00^{(2011.01)}$    $H03M\ 7/30^{(2006.01)}$
$G01S\ 19/30^{(2010.01)}$

(52) Cooperative Patent Classification (CPC):
**H04B 1/70735; G01S 19/30; H03M 5/06;
H04J 13/0022;** H03M 7/3059

(54) **METHOD FOR BUILDING A TARGET SEQUENCE OF BINARY SAMPLES OF A CODE
SEQUENCE COMPRISING BINARY CHIPS**

VERFAHREN ZUM ERSTELLEN EINER ZIELSEQUENZ BINÄRER MUSTER EINER BINÄRCHIPS
UMFASSENDEN CODESEQUENZ

PROCÉDÉ DE CONSTRUCTION D'UNE SÉQUENCE CIBLE D'ÉCHANTILLONS BINAIRES D'UNE
SÉQUENCE DE CODES COMPRENANT DES PUCES BINAIRES

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**10.12.2025 Bulletin 2025/50**

(73) Proprietor: **GMV AEROSPACE AND DEFENCE,
S.A.U.
28760 Madrid Tres Cantos (ES)**

(72) Inventor: **LÓPEZ ALMANSA, José María
28760 Tres Cantos (ES)**

(74) Representative: **Elion IP, S.L.
Paseo Castellana, 150-4 dcha
28046 Madrid (ES)**

(56) References cited:
**WO-A1-96/37789**

- **TRAN VINH T ET AL: "GNSS receiver
implementations to mitigate the effects of
commensurate sampling frequencies on DLL
code tracking", GPS SOLUTIONS, SPRINGER
BERLIN HEIDELBERG, BERLIN/HEIDELBERG,
vol. 22, no. 1, 7 December 2017 (2017-12-07),
pages 1 - 11, XP036401539, ISSN: 1080-5370,
[retrieved on 20171207], DOI: 10.1007/
S10291-017-0690-X**

**Description**

**TECHNICAL FIELD**

The present disclosure can be applied to any signal-processing or communications area where binary sampling is needed; the disclosure is particularly relevant in the field of signal processing for GNSS receivers.

**BACKGROUND**

Binary sampling is a widely required process in multiple technological applications, such as electronics, communications, signal analysis, signal processing, etc.

In binary sampling, a code sequence, $C$, of $L_C$ binary chips, $C = [c_0, c_1, c_2 \ldots c_{L_C-1}]$, is given; each chip $c_i$ can take two possible values (1 or 0), $\forall i \in [0 \ldots (L_C - 1)]$, and the code sequence $C$ has a given chip rate, $f_C$, of $f_C$ chips/s (i.e., a chip period $T_C = \dfrac{1}{f_C}$ seconds / chip).

In regard to the present disclosure, the problem of binary sampling can be stated as how to find a target sequence of binary samples, $S$, this target sequence having $L_S$ samples, $S = [s_0, s_1, s_2 \ldots s_{L_S-1}]$, with a sample rate of $f_s$ samples/s (i.e., a sample period $T_s = \dfrac{1}{f_s}$ seconds / sample) and an initial phase $\tau_s$ (in seconds), where each sample $s_k$ can take two possible values (1 or 0), $\forall k \in [0 \ldots (L_s - 1)]$, in such a way that $s_k = c_i$, with $i$ and $k$ fulfilling the following condition:

$$i \cdot T_{\text{ch}} \leq k \cdot T_s + \tau_s < (i+1) \cdot T_{\text{ch}} \qquad \text{Eq. 1}$$

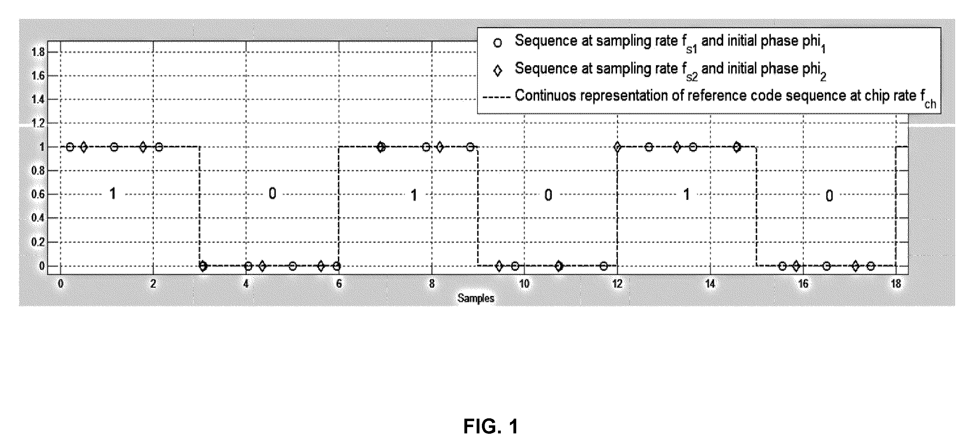

As an illustration example, Figure 1 shows an interval of an example of code sequence $C$ ([1,0,1,0,1,0...]) sampled at two different sampling rates, $f_{s_1}$ and $f_{s_2}$, and having initial code phases $phi_1$ and $phi_2$, respectively. In Figure 1, the two sampling sequences, $S_1$ and $S_2$, are represented with circles and with diamonds, respectively. Each sample takes the value 1 or 0 of the chip of the code sequence $C$ where the sample falls. In particular, the two sampled sequences, $S_1$ and $S_2$, of this example are as follows:

$$S_1 = [1,1,1,0,0,0,0,1,1,1,0,0,0,1,1,1,0,0,0]$$

$$S_2 = [1,1,0,0,0,1,1,0,0,1,1,1,0,0,1,1,0,0,0]$$

A conventional and widely known mechanism for sampling a code sequence can be summarized as follows:

- The code sequence $C$ is assumed to be available, either because it is stored in a reference vector or because it is possible to generate it on the fly, or by any other means.
- For each target sample to be generated, its corresponding sampled time is computed, starting at zero for the first sample and propagating the initial code phase.
- For each target sample time, the chip index (within the code sequence) where the sample falls must be found, so that Eq. 1 is fulfilled. The binary value (1 or 0) of the corresponding chip will be the binary value of the sample.
- Proceed as above for all the samples in the vector.

A slightly different approach, which is also widely known, involves sweeping on the chips (instead of on the samples), finding those chip times for which the chips switch value (1 to 0 or 0 to 1). Those samples whose sampling times fall within the chip times will take the specific binary value of the chip.

Both of the above techniques (either sweeping on sample domain or on chip domain) require that the original code sequence is available: in fact, the code sequence is used as a reference for providing the chip values in the process of sample generation.

For some applications, it is convenient to store the code sequence and/or the sampled sequence in what, throughout the present disclosure, is called packed format. This packed or packing implies that each binary element (either each chip of the code sequence or each sample of the sampled sequence) is stored in a bit (valued 1 or 0) of a N-bit word. Just as an example, the sequence [1,1,1,0,0,0,0,1] composed of N=8 bits, may be represented by the integer number 225, because the bit representation of the number 225 coincides specifically with that sequence. This can be generalized for any set of N elements and N-bit words.

Packing may be a convenient approach that can contribute to memory and computational savings. Thus, it is common practice in some kinds of GNSS receivers and other communications systems.

When packing is considered, the conventional sampling mechanisms described above (on sample domain or chip domain) needs to be consequently adapted, accounting for the fact that each binary element (either the chip in the code sequence and/or the sample in the sampled sequence) is not linearly stored (that is, in a vector containing the binary elements in an element-to-element basis), but they are packed within the bits of sets of N-words. Therefore, additional binary operations (bit masking, bit shifting, AND, OR, XOR, NOT, etc.) must be included in the process, which is, in any case, a standard and widely known mechanism.

Sampling a code sequence to produce a sampled sequence can be a computationally expensive process. In order to avoid the need of on-the-fly sampling, in particular for the case of those GNSS receivers that are short of computational capabilities, several techniques have been proposed in the literature, making use of look-up tables that contain sets of sampled sequences at different sampling conditions:

- Storing sets of sampled codes, including several values for the initial code phase (with a phase resolution according to a given criterion).
- Storing sets of over-sampled codes (i.e., with sampling frequency higher than the target sampled sequence) which will be used as a basis for computing the actual required sampled sequence.

Both these storing approaches (which require keeping in memory sets of sampled sequences at different sampling parameters) avoid the need for on-the-fly sampling, but require large amounts of memory, making them not convenient for those applications where memory is a critical and expensive resource, as mass electronics and space applications. On the other hand, the conventional sampling approach -which consists in making a sweep for all samples of the target sequence or for all chips of the code in order to find the correspondence (between target samples and chips) that provides, for each sample, the required binary value-, has the problem of requiring large computational capabilities that may be not affordable for many applications.

In the context of satellite communication using spread-spectrum signals, the document WO9637789A1 discloses a PRN (pseudorandom noise) code generator in a GPS (Global Positioning System) receiver for decoding received PRN encoded signals, the code generator generating a replica of the PRN code.

DESCRIPTION

The present disclosure proposes a method for getting a sampled binary sequence that represents the sampling of an underlying binary code sequence, which, unlike the conventional sampling approach (which must sweep for the whole code sequence, looking at all the chips, in order to produce a target sequence) does not need to operate on the underlying binary code sequence.

In the present disclosure, the underlying binary code sequence is also referred to as original code sequence or code sequence and denoted as $C$. As indicated in the background section, this code sequence, $C$, has $L_C$ binary chips and a chip rate $f_C$ *chips/second* (i.e., a chip period $T_C = \dfrac{1}{f_C}$ *seconds/chip* ).

A first aspect of the present disclosure relates to a method for building a target sequence $S$ of binary samples, the target sequence S of binary samples representing a sampling at a sampling rate $f_S$, a sampling period $T_S = \dfrac{1}{f_S}$ and an initial phase $\tau_S$ of the original code sequence $C$.

The target sequence is built by concatenating sets of samples taken from a reference sequence $R$ of $L_R$ samples, the reference sequence $R = [r_{(0)} \dots r_{(LR}\text{-}1)]$ being an already sampled sequence of the original code sequence $V_C$ having a sampling rate $f_R > f_C$, a sampling period $T_R = \dfrac{1}{f_R}$ and an initial phase $\tau_R$. And either $f_S \neq f_R$ and/or $\tau_S \neq \tau_R$. In the reference sequence R, each sample $r_{(i)}$ has an index i belonging to the interval [0, $(L_R$ - 1)].

According to the method, the binary values of the samples contained in each of said sets of samples coincide, sample by sample, in both the target and the reference sequences, there being differences between the reference and the target sequences. These differences between the target and the reference sequences are compensated by duplicating or discarding at least one sample of the reference sequence between each couple of sets of samples. The index of at least one sample to be duplicated or discarded (between two sets of samples from the reference sequence when building the target sequence) is mathematically computed using the sampling rates and the initial phases of the target and the reference sequences.

Actually, the present disclosure arises from the inventor realizing that, when comparing two sequences that represent the sampling of a binary code at two different sampling conditions, there are common sets or intervals of samples that share, sample by sample, exactly the same binary value (1 or 0) in the two sequences. And that in the transitions or boundaries between those common sets of samples, the difference between the two sequences is an excess or a defect of at least one sample.

Thus, based on the known sampling parameters (sampling rate and initial phase) of both the target and reference sequences, the present disclosure shows at least a way of mathematically computing the indexes of the samples that represent the boundaries between those common sets or intervals of samples.

It is important to bear in mind that in the method herein disclosed, reference is made to the code sequence $C$ but this code sequence $C$ is actually not needed.

The disclosure does not impose any constraint either on the sampling rates of the reference sequence R and of the target sequence S. Actually, both sampling rates can be arbitrary.

The closer the sampling rates between the reference sequence and the target sequence, the better the computational efficiency of the method. Thus, in certain embodiments, the sampling rates of both the reference sequence and the target sequence are close to each other, and jointly close to an integer multiple of the chip rate of the original code sequence, and the computation efficiency is thus improved.

In certain embodiments the sampling rate $f_R$ of the reference sequence $R$ is an integer multiple of the chip rate $f_C$, that is, $f_R = M_S \cdot f_C$, being $M_S = round\left(\frac{f_S}{f_C}\right)$ and $M_S > 1$, with $f_S$ being the sampling rate of the target sequence;

each set of samples of the reference sequence $R$ is delimited by samples having indexes i, defined within the reference sequence, given by each couple of two consecutive elements from a vector $[m_k]$, with $k = [0 ... (N_S - 1)]$, wherein vector $[m_k]$ is defined as follows:

- if

$$f_S > f_R:$$

$$N_S = ceil[f_S \cdot N_C \cdot M_S \cdot (T_R - T_S)],$$

$$[n_k] = \left[\frac{(k+1)\cdot T_R - (T_S - \tau_S)}{T_R - T_S} - k\right], \qquad [m_k] = floor([n_k]),$$

- 

$$\text{if } f_S < f_R:$$

$$N_S = ceil[f_S \cdot N_C \cdot M_S \cdot (T_S - T_R)],$$

$$[n_k] = \left[\frac{(k+1)\cdot T_R - \tau_S}{T_S - T_R} + k\right], \qquad [m_k] = ceil([n_k]),$$

where *floor* and *ceil* represent integer rounding towards $-\infty$ and $\infty$, respectively, and wherein the target sequence $S$ is computed as follows:

- if

$$f_S > f_R$$

$$S = \left[\begin{matrix} r_{(0)} \cdots r_{(m_0)}, r_{(m_0)}, r_{(m_0+1)} \cdots r_{(m_1)}, r_{(m_1)}, \\ r_{(m_1+1)} \cdots, \cdots r_{\left(m_{(N_S-1)}\right)}, r_{\left(m_{(N_S-1)}\right)}, r_{\left(m_{(N_S-1)}+1\right)} \cdots r_{(L_R-1)} \end{matrix}\right]$$

where samples $r_{(mk)}$ with indexes $i = m_k$ from vector $[m_k]$, said samples defined within the reference sequence, are duplicated when building the target sequence,

- if

$$f_S < f_R:$$

$$S = \begin{bmatrix} r_{(0)}, \ldots, r_{(m_0-1)}, r_{(m_0+1)} \cdots r_{(m_1-1)}, r_{(m_1+1)}, \\ \ldots, \ldots r_{(m_{(N_S-1)}-1)}, r_{(m_{(N_S-1)}+1)}, \cdots, r_{(L_R-1)} \end{bmatrix}$$

where reference samples $r_{(mk)}$ with indexes $i = m_k$ from vector $[m_k]$ are discarded when building the target sequence.

In certain embodiments, the sampling rate $f_S$ of the target sequence $S$ is an integer multiple of the chip rate $f_C$, that is, $f_S = M_R \cdot f_C$, being $M_R = round(\frac{f_R}{f_C})$ and $M_R > 1$, with $f_R$ being the sampling rate of the reference sequence, each set of samples of the reference sequence $R$ is delimited by samples having indexes $i$, defined within the reference sequence, given by each couple of two consecutive elements from a vector $[m'_e]$, with $e = [0 \ldots N_R - 1]$, wherein vector $[m'_e]$ is defined as follows:

- if

$$f_S < f_R:$$

$$N_R = ceil[f_R \cdot N_C \cdot M_R \cdot (T_S - T_R)],$$

$$[n'_e] = \left[ \frac{(e+1) \cdot T_S - (T_R - \tau_R)}{T_S - T_R} - 1 \right], \; [m'_e] = floor([n'_e])$$

- if

$$f_S > f_R:$$

$$N_R = ceil[f_R \cdot N_C \cdot M_R \cdot (T_R - T_S)]$$

$$[n'_e] = \left[ \frac{(e+1) \cdot T_S - \tau_R}{T_R - T_S} + 1 \right], \; [m'_e] = ceil([n'_e])$$

where *floor* and *ceil* represent integer rounding towards -∞ and ∞, respectively, and wherein the target sequence $S$ is computed as follows:

- if

$$f_S < f_R:$$

$$S = \begin{bmatrix} r_{(0)}, \ldots, r_{(m'_0-1)}, r_{(m'_0+1)}, \cdots, r_{(m'_1-1)}, r_{(m'_1+1)}, \\ \ldots, \ldots, r_{(m'_{(N_R-1)}-1)}, r_{(m'_{(N_R-1)}+1)}, \cdots, r_{(L_R-1)} \end{bmatrix}$$

where samples $r_{(m'_e)}$, with indexes $i = m'_e$ from vector $[m'_e]$ are discarded when building the target sequence,

- if

$$f_S > f_R:$$

$$S = \begin{bmatrix} r_{(0)} \cdots r_{(m'_0)}, r_{(m'_0 - \Delta_0)}, r_{(m'_0+1)} \cdots r_{(m'_1)}, r_{(m'_1 - \Delta_1)}, r_{(m'_1+1)} \cdots \\ \cdots, r_{(m'_{(N_R-1)})}, r_{(m'_{(N_R-1)} - \Delta_{(N_R-1)})}, r_{(m'_{(N_R-1)}+1)}, r_{(L_R-1)} \end{bmatrix}$$

where samples $r_{(m'_e)}$ with indexes $i = m'_e$ from vector $[m'_e]$ are duplicated when building the target sequence, and wherein $\Delta_e$ is:

if

$$modulus(m'_e, M_R) = 0 \Rightarrow \Delta_e = 1$$

if

$$modulus(m'_e, M_R) \neq 0 \Rightarrow \Delta_e = 0.$$

In certain embodiments, the sampling rates of neither the reference sequence nor the target sequence are integer multiples of the chip rate. In these embodiments, each set of samples of the reference sequence $R$ is delimited by samples having indexes given by each couple of two consecutive elements from a vector $[q_j]$, the vector $[q_j]$ being computed as rounding of the elements of another vector $[p_j]$ computed by the combination of the elements from a first vector $[n_k]$ and the elements of a second vector $[n'_e]$.

The first vector $[n_k]$ with $k = [0 \ldots N_S - 1)]$ is defined for the target sequence $S$ as follows:

a) if

$$f_S > M_S \cdot f_C:$$

$$N_S = ceil[f_S \cdot N_C \cdot M_S \cdot (T'_S - T_S)], [n_k] = \left[ \frac{(k+1) \cdot T'_S - (T_S - \tau_S)}{T'_S - T_S} - k \right],$$

b) if

$$f_S < M_S \cdot f_C:$$

$$N_S = ceil[f_S \cdot N_C \cdot M_S \cdot (T_S - T'_S)], \quad [n_k] = \left[ \frac{(k+1) \cdot T'_S - \tau_S}{T_S - T'_S} + k \right]$$

where $M_S$ is a number $M_S = round\left(\frac{f_S}{f_C}\right)$, $M_S > 1$, and $T'_S = \frac{1}{M_S \cdot f_C}$.

And the second vector $[n'_e]$ with $e = [0 \ldots (N_R - 1)]$ is defined for the reference sequence R as follows:

c) if

$$f_R > M_R \cdot f_C:$$

$$N_R = ceil[f_R \cdot N_C \cdot M_R \cdot (T'_R - T_R)], \qquad [n'_e] = \left[ \frac{(e+1) \cdot T'_R - (T_R - \tau_R)}{T'_R - T_R} \right]$$

d) if

$$f_R < M_R \cdot f_C:$$

$$N_R = ceil[f_R \cdot N_C \cdot M_R \cdot (T_R - T'_R)] \ , \ [n'_e] = \left\lceil \frac{(e+1) \cdot T'_R - \tau_R}{T_R - T'_R} \right\rceil$$

where $M_R$ is a number $M_R = round\left(\frac{f_R}{f_C}\right)$, $M_R > 1$, and $T'_R = \frac{1}{M_R \cdot f_C}$ .

The elements in vector $[p_j]$ are sorted in increasing order from 0 to $\infty$, where each element $q_j$ is computed by rounding the corresponding element $p_j$, for example, as follows:

$$[q_j] = trunc[p_j + \alpha_j \cdot \delta_j]$$

where:

- *trunc* is rounding towards $-\infty$ if element $p_j$ is related to a sequence under the condition indicated in any of cases a) or c) above, or towards $\infty$ if element $p_j$ is related to a sequence under the condition indicated in any of cases b) or d) above,
- $\delta_j$ and $\alpha_j$ are two integer numbers, defined for each index $j$ as follows:

    o if the reference sequence and the target sequence are from cases a) or c), $\delta_j = 0$,
    o if the reference sequence and the target sequence are from cases b) or d), $\delta_j = 0$,
    o if the reference sequence is from cases a) or c) and the target sequence is from cases b) or d), $\delta_j$ is the number of elements in the vector $[p_j]$ with indexes smaller than $j$ corresponding to the reference sequence and $\alpha_j = 1$,
    o if the reference sequence is from cases b) or d) and the target sequence is from cases a) or c), $\delta_j$ is the number of elements in the vector $[p_j]$ with indexes smaller than $j$ corresponding to the target sequence and $\alpha_j = -1$.

In these embodiments, the target sequence is built as concatenation of the sets of samples from the reference sequence delimited by consecutive couples of elements of vector $[q_j]$, and where, for each set, at least one sample is either duplicated if the given element $q_j$ corresponds to a sequence from cases a) or c), or discarded if the given element $q_j$ corresponds to a sequence from cases b) or d). And, when for a given element $q_j$, a reference sample is to be duplicated, the index of the reference sample to be duplicated is:

- $q_j$ if

$$nodulus\left(q_j, M_R\right) \neq 0 \ ,$$

- $q_j$ - 1 if

$$modulus\left(q_j, M_R\right) = 0,$$

and, when for a given element $q_j$, a reference sample is to be discarded, the index of the reference sample to be discarded is given by the element $q_j$.

The disclosure does not impose any constraint about the fact that the target sequence $S$ and/or the reference sequence $R$ are vectors of consecutive samples or packed in N-bit words. In case of sequences packed in N-bit words, the transitions or boundaries that the method mathematically computes are represented by two indexes per transition (instead of one), in order to account for both the word index and the bit index within the word. In embodiments wherein a sequence is packed in N-bit words, the binary operations (such as bit masking, bit shifting, AND, OR, XOR, NOT, etc.) are included in order to duplicate or to discard the proper samples (bits) from the words.

A further aspect of the present disclosure relates to a signal-processing device, the signal-processing device comprising at least one processor, and at least one memory. The at least one memory is configured, together with the at least one processor, to cause the signal-processing device to carry out the steps of a method as defined in the foregoing.

In certain embodiments the signal-processing device is a GNSS receiver. In such embodiments, using the method disclosed herein provides the GNSS receiver with the required sets of sampled PRN vectors, to be used as replica vectors for processing in the GNSS receiver, in an efficient manner.

The different aspects and embodiments defined in the foregoing may be combined with one another, as long as they are compatible with each other.

Additional advantages and features of the present disclosure will become apparent from the detail description that follows and will be particularly pointed out in the appended claims.

## BRIEF DESCRIPTION OF THE DRAWINGS

To complete the description and in order to provide for a better understanding of the disclosure, a set of drawings is provided. Said drawings form an integral part of the description and illustrate embodiments of the disclosure, which should not be interpreted as restricting the scope of the disclosure, but just as examples of how the disclosure can be carried out. The drawings comprise the following figures:

Figure 1 shows an interval of an example of code sequence $V_{ch}$ sampled at two different sampling rates.

Figures 2A and 2B show respective examples of the variable number of chips, including portions of desync sequences of samples, being oversync in Fig. 2A and subsync in Fig. 2B.

## DETAILED DESCRIPTION

An essential point that sets this disclosure apart from the conventional methods is that, for the production of the target sequence $S$ of binary samples, this disclosure makes use of another already-sampled sequence (at a different sampling rate and/or initial phase from the sampling rate and/or initial phase of the target sequence), referred to as reference sequence $R$, instead of making use of the original code sequence $C$, with sets of samples from the reference sequence $R$ being directly taken and concatenated to produce the target sequence $S$.

The code sequence, C, has $L_C$ binary chips, C = $[c_0, c_1, c_2 \dots c_{L_c-1}]$, where each chip $c_i$ can take two possible values 1 or 0, $\forall\, i \in [0 \dots L_C - 1]$, and has a chip rate $f_C$ *chips/second* (i.e., a chip period $T_C = \dfrac{1}{f_C}$ *seconds/chip*).

The target sequence $S$ is a sequence of $L_S$ samples, $S = [s_0, s_1, s_2 \dots s_{(L_S}-1)]$, where each sample $s_k$ can take two possible values 1 or 0, $\forall\, k \in [0 \dots (L_S - 1)]$, with a sample rate $f_S$ *samples/second* (i.e., a sample period $T_S = \dfrac{1}{f_S}$ *seconds/sample*) and an initial phase $\tau_S$ (in seconds). The sample sequence S represents the sampling of the code sequence C in the sense that $s_k = c_i$, with $i$ and $k$ fulfilling the following condition:

$$i \cdot T_C \leq k \cdot T_S + \tau_S < (i+1) \cdot T_C \qquad\qquad \text{Eq. 2}$$

The reference sequence of binary samples, R, used in the present disclosure is a sequence having $L_R$ samples, $R = [r_0, r_1, r_2 \dots r_{(L_R}-1)]$, where each sample $r_k$ can take two possible values 1 or 0, $\forall\, k \in [0 \dots (L_R - 1)]$, with a sample rate $f_R$ *samples/second* (i.e., a sample period $T_R = \dfrac{1}{f_R}$ *seconds/sample*) and an initial phase $\tau_R$ (in seconds). The reference sequence R represents the sampling of the code sequence C in the sense that $r_k = c_i$, with $i$ and $k$ fulfilling the following condition:

$$i \cdot T_C \leq k \cdot T_R + \tau_R < (i+1) \cdot T_C \qquad\qquad \text{Eq. 3}$$

This reference sequence $R$ is assumed to be available in advance, represents the sampling of the code sequence C and is used for building the target sequence S.

For convenience and easiness of understanding, most of the present disclosure focuses on the case of sequences composed of vectors of consecutive samples, that is, on sequences that are not packed. But extrapolation to the case where the sequences are packed may be assumed and an example is provided later.

Prior to providing a detailed description of the present disclosure, and as a basis thereof, some important implications that the inventor has found out about sampled sequences are analyzed. This analysis is general, and is applicable to any sample sequence, therefore in the analysis that follows the sequence will be denoted as $X$ (instead of the specific symbol R or S, used above to denote the reference and the target sequences, respectively) and is expressed as $X = [x_0, x_1, x_2 \dots x_{(L_X}-1)]$.

Throughout this description, for easiness of understanding, the sampling rates are assumed to be constant in time; but, conceptually, they could be variable, in such a way that, for a given time $t$ within the sequence, the sampling rate $f_X$ ($t$) can be expressed in terms of the sampling-rate derivatives as follows:

$$f_X(t) = f_{X,0} + \dot{f}_X \cdot t + \frac{1}{2} \cdot \ddot{f}_X \cdot t^2 + \cdots$$

An important point of the present disclosure is to realize that the number of samples of a sample sequence $X$ (having a sampling rate $f_X$) that falls on any code chip $i$ of the original code sequence $C$ (having a chip rate of $f_C$) can take just two possible values, $M_{A_X}$ or $M_{B_X}$, i.e., any code chip i always contains either $M_{A_X}$ or $M_{B_X}$ samples of $X$. Moreover, $M_{A_X}$ and $M_{B_X}$ depend on a number $M_X = round\left(\frac{f_X}{f_C}\right)$, as follows:

a) Oversync case, that is, if

$$f_X > M_X \cdot f_C \Rightarrow M_{A_X} = M_X; \; M_{B_X} = M_X + 1$$

b) Subsync case, that is, if

$$f_X < M_X \cdot f_C \Rightarrow M_{A_X} = M_X; \; M_{B_X} = M_X - 1$$

c) Sync case, that is, when

$$f_X = M_X \cdot f_C \Rightarrow M_{A_X} = M_X; \; M_{B_X} = Non\ Applicable$$

In the following, the first two cases (oversync and subsync) are generically referred to as desync (abbreviation from desynchronized). Notice that, in each of them, the number of samples per chip differs in just $\pm 1$ sample, either in excess or in defect. In the sync case (abbreviation from synchronized), for which there is an integer ratio between the sampling rate of the sampled sequence and the chip rate of the code, all the chips have the same number of samples, $M_{A_X} = M_X$.

Regarding the desync cases, and except for $f_X = \frac{M_X \cdot f_C}{2}$ (when $M_{A_X}$ and $M_{B_X}$ are equiprobable), there are usually more chips with $M_{A_X}$ than with $M_{B_X}$ samples. For this reason, the fact of having either $M_{A_X}$ or $M_{B_X}$ ies hereafter defined as nominal or non-nominal events, respectively.

For any desync sample sequence $X$ with number $M_X$, a sync sequence $V_0$ is defined as a sequence of $L_0 = M_X \cdot N_C$ samples with sampling rate $f_0 = M_X \cdot f_C$, sampling period $T_0 = \frac{1}{f_0}$ and initial phase $\tau_0 = 0$, representing the sampling of the same original code sequence $C$ as $X$; let us express this sync sequence as: $V_0 = [v_0, v_1, v_2 ... v_{(L_0-1)}]$.

As way of example, let us assume there are two desync sample sequences, one of them oversync and the other subsync, with sampling parameters (expressed as a function of the parameters of the code sequence $C$):

•

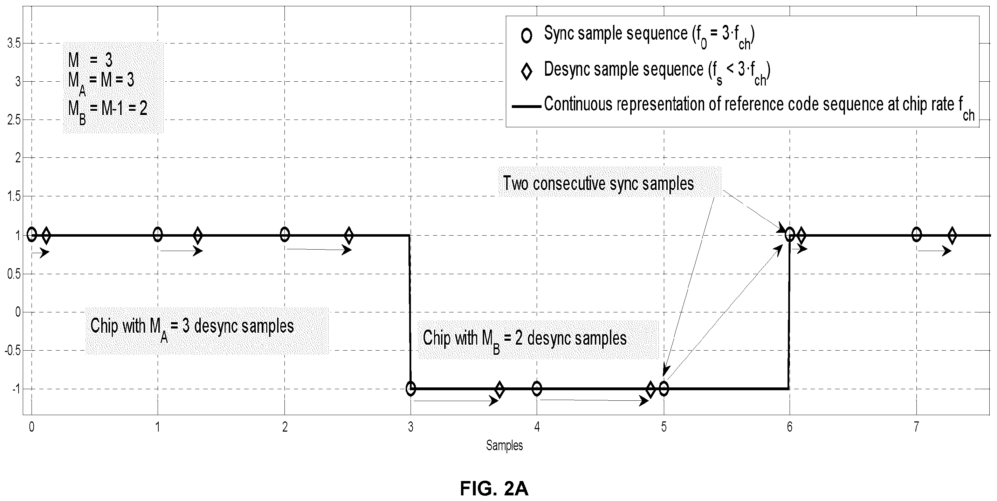

OVERSYNC (FIG 2A): Eq. 4a

Sampling rate: $f_{over} = 3.414 \cdot f_C \rightarrow M_{over} = round(3.414) = 3$

Initial phase: $\tau_{over} = 0.34 \cdot T_C$.

•

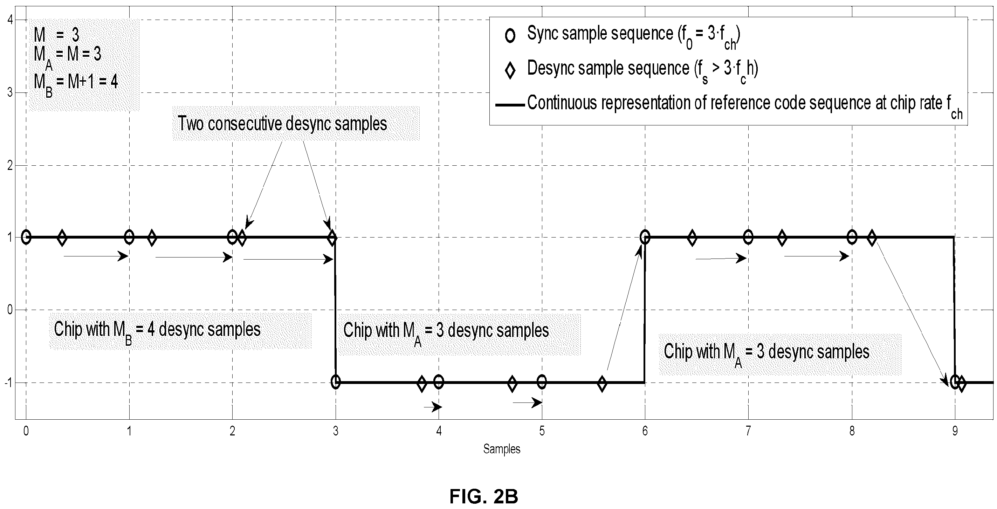

SUBSYNC (FIG 2B): $\qquad$ Eq. 4b

Sampling rate: $f_{sub} = 2.52 \cdot f_C \rightarrow M_{sub} = round(2.52) = 3$

Initial phase: $\tau_{sub} = 0.117 \cdot T_C$.

Notice that in both cases, the number $M_X$ = 3. Let us compare each of these desync sequences with the corresponding sync sequence $V_0$ (i.e., a sequence of samples with $f_0 = 3 \cdot f_C$). Figures 2A and 2B present, as an example, portions of the desync sequences of samples represented by diamonds (oversync in Fig. 2A and subsync in Fig. 2B), as well as the corresponding sync sample sequence (with circles). Notice that all the chips in the sync sequence have $M_X$ = 3 sync samples, but this is not always the case for the desync sequences:

- Oversync (Fig. 2A): there are two chips with $M_{A_X}$ = 3 desync samples and one chip with $M_{B_X}$ = 4 desync samples. Notice that a general pattern occurs consisting of an alternation between desync and sync samples: each desync sample (diamond) is, in general, followed by a sync sample (circle), as indicated by the rightwards arrows from each diamond to the next circle. However, sometimes occurs that one desync sample is followed by another desync sample; in Fig. 2A this occurs once, between samples 2 and 3, thus breaking the pattern. This non-nominal event is the reason why the first chip has 4 desync samples instead of 3 desync samples.

- Subsync (Fig. 2B) shows the complementary case. In this case, the general pattern consists of an alternation between sync and desync samples: each sync sample (circle) is followed by a desync sample (diamond). However, sometimes occurs that one sync sample (circle) is followed by another sync sample; in Fig. 2B this occurs once, between samples 5 and 6. This non-nominal event is the cause for the second chip having 2 desync samples instead of 3 desync samples.

In the following, non-nominal sync samples are defined as those samples in the sync sequence that are involved in a non-nominal event:

- In the case shown in Fig. 2A, the non-nominal event is associated to a couple of two consecutive desync samples before a sync sample. The sync sample just after the second desync sample of each couple (i.e., the sync sample that has been preceded by a desync sample in excess) is defined as a non-nominal sync sample. In Fig. 2A, sync sample 3 is a non-nominal sync sample.

- In the case shown in Fig. 2B, the non-nominal events are related to couples of two consecutive sync samples before a desync sample. The first sample of each of those couples (i.e., the sync samples previous to the ones that are *overpassed by* a desync sample) is defined as a non-nominal sync sample. In Fig. 2B, sync sample 5 is a non-nominal sync sample.

Another important point of the present disclosure is the inventor having realized that, given the sampling rate $f_X$ and the initial phase $\tau_X$, and for any of the two desync cases, it is possible to mathematically compute the indexes of the non-nominal sync samples that represent the discrepancies between the desync and the sync sequences. Along the whole sync sequence, there will be $N_X$ non-nominal sync samples, with indexes $m_k$ that can be computed as follows:

a) Oversync case, if $f_X > f_0$:

$$N_X = ceil[f_X \cdot N_C \cdot M_X \cdot (T_0 - T_X)],$$

$$[n_k] = \left[\frac{(k+1) \cdot T_0 - (T_X - \tau_X)}{T_0 - T_X} - k\right], \qquad [m_k] = floor([n_k]), \forall\, k\, \in [0, N_X - 1] \qquad \text{Eq. 5a}$$

b) Subsync case, if $f_X < f_0$:

$$N_X = ceil[f_X \cdot N_C \cdot M_X \cdot (T_X - T_0)]$$

$$[n_k] = \left[\frac{(k+1) \cdot T_0 - \tau_X}{T_X - T_0} + k\right], \quad [m_k] = ceil([n_k]), \qquad \forall\, k\, \in [0, N_X - 1] \qquad \text{Eq. 5b}$$

c) Sync case, if $f_X = f_0$:

$N_X = 0 \Rightarrow$ trivial case where both sequences are equal (regardless of $\tau_X$).
$[n_k]$, $[m_k] \equiv$ *Non Applicable*

As previously explained, an important point of the present disclosure is realizing the following facts:

- As long as a sample falls on a chip, the sample in the sampled sequence takes the binary value of the chip (exactly 1 or 0), regardless of the (in a general case, shifted) position of the sample within the chip (that is, as long as the inequality defined above as Eq. 2 or Eq. 3 are fulfilled and the sample time falls within the time range that defines the chip).
- The binary values of all the sync samples with index $m$ contained between two consecutive non-nominal sync samples (i.e., $\forall m$, with $(m_k + 1) < m < (m_{(k+1)} - 1)]$ coincide, sample by sample, with the binary values of an interval of as many samples in the desync sequence, since those samples between non-nominal samples are, by definition, nominal samples, and all these nominal samples in that interval of the desync sequence correspond to the nominal case of $M_A = M_X$ samples per chip.
- The non-nominal sync samples represent the differences between the sync and the desync sequences in the following way:

  o If the desync sequence is oversync (i.e., case a), any non-nominal sync sample is non-nominal in defect, i.e., a sample is lacking in the sync sequence, compared to the oversync sequence.
  o If the desync sequence is subsync (i.e., case b), any non-nominal sync sample is non-nominal in excess, i.e., that sync sample would not be needed, compared to the subsync sequence.

Thus, for a desync sequence $X$, the corresponding sync sequence $V_0$ together with the set of $N_X$ non-nominal sync sample indexes $m_k$ contain exactly the same information as the sequence $X$. In fact, the sequence $X$ can be expressed from $V_0$ as follows:

Oversync case, $f_s > f_0$:

$$X = \begin{bmatrix} \mathcal{V}_{(0)} \cdots \mathcal{V}_{(m_0)}, \mathcal{V}_{(m_0)}, \mathcal{V}_{(m_0+1)} \cdots \mathcal{V}_{(m_1)}, \mathcal{V}_{(m_1)}, \mathcal{V}_{(m_1+1)} \cdots, \\ \cdots, \mathcal{V}_{\left(m_{(N_X-1)}\right)}, \mathcal{V}_{\left(m_{(N_X-1)}\right)}, \mathcal{V}_{(m_{(N_X-1)}+1)} \cdots \mathcal{V}_{(L_0-1)} \end{bmatrix} \qquad \text{Eq. 6a}$$

where the non-nominal sync samples $v_{(mk)}$ have been duplicated because, in the sync sequence $V_0$, they are in defect compared to the oversync sequence $X$.
Subsync case, $f_X < f_0$:

$$X = \begin{bmatrix} \mathcal{V}_{(0)}, \cdots, \mathcal{V}_{(m_0-1)}, \mathcal{V}_{(m_0+1)}, \cdots, \mathcal{V}_{(m_1-1)}, \mathcal{V}_{(m_1+1)}, \cdots, \cdots, \\ V_{(m_{(N_X-1)}-1)}, V_{(m_{(N_X-1)}+1)}, \cdots, \mathcal{V}_{(L_0-1)} \end{bmatrix} \qquad \text{Eq. 6b}$$

where the non-nominal sync samples $v_{(mk)}$ have been discarded since, in the sync sequence $V_0$, they are in excess compared to the subsync sequence $X$.

Alternatively, the sync sequence $V_0$ can be derived from the desync sequence $X$ by concatenating intervals of samples taken from the sequence $X$ and properly managing the transition samples between those intervals. In this case, the indexes for the transition samples (labelled now as $[n'_e]$ and $[m'_e]$, respectively before and after integer truncation) are defined on the domain of the desync sequence (instead of the domain of the sync sequence):

Oversync case, $f_X > f_0$:

$$N_X = ceil[f_X \cdot N_C \cdot M_X \cdot (T_0 - T_X)],$$

$$[n'_e] = \left[\frac{(e+1) \cdot T_0 - (T_X - \tau_X)}{T_0 - T_X}\right], [m'_e] = floor([n'_e]), \forall\, e \in [0, N_X - 1] \qquad \text{Eq. 7a}$$

$$V_0 = \begin{bmatrix} x_{(0)}, \ldots, x_{(m_0'-1)}, x_{(m_0'+1)}, \ldots, x_{(m_1'-1)}, x_{(m_1'+1)}, \ldots, \\ \ldots x_{(m_{(N_X-1)}'-1)}, x_{(m_{(N_X-1)}'+1)}, \ldots, x_{(L_X-1)} \end{bmatrix} \qquad \text{Eq. 7b}$$

where samples with indexes $x_{(m_e')}$ have been discarded from the oversync sequence $X$ since they are in excess compared to the sync sequence $V_0$.

Subsync case: $f_X < f_0$:

$$N_X = ceil[f_X \cdot N_C \cdot M_X \cdot (T_X - T_0)]$$

$$[n_e'] = \left[\frac{(e+1)\cdot T_0 - \tau_X}{T_X - T_0}\right], \; [m_e'] = ceil([n_e']), \; \forall \, k \; \in [0, N_X - 1] \qquad \text{Eq. 7c}$$

$$V_0 = \begin{bmatrix} x_{(0)} \ldots x_{(m_0')}, x_{(m_0'-\Delta_0)}, x_{(m_0'+1)} \cdots x_{(m_1')}, x_{(m_1'-\Delta_1)}, x_{(m_1'+1)} \cdots, \ldots \\ x_{(m_{(N_X-1)}')}, x_{(m_{(N_X-1)}'-\Delta_{(N_X-1)})}, x_{(m_{(N_X-1)}'+1)} \cdots x_{(L_X-1)} \end{bmatrix} \qquad \text{Eq. 7d}$$

where samples with indexes $x_{(m_e'-\Delta_e)}$ have been duplicated from the subsync sequence $X$ because they are in defect compared to the sync sequence $V_0$, with $\Delta_e$ being:

if

$$modulus(m_e', M_X) = 0 \Rightarrow \Delta_e = 1$$

if

$$modulus(m_e', M_X) \neq 0 \Rightarrow \Delta_e = 0$$

Note that this $\Delta_e$ was not needed in the previous case when the desync sequence was derived from the sync sequence. This has to do with the fact that, in the previous case, the starting point was the sync sequence $V_0$, which is fully synchronized with the original code sequence $C$, therefore, preserving exactly the code information. However, in this second case, the sequence used as starting point, $X$, is not synchronized with the original code sequence C, so this extra correction is required in order to introduce the (initially absent) synchronization.

As already stated, the purpose of this disclosure is a method to build a target sample sequence S (which represents the sampling, at sampling rate $f_S$ and initial phase $\tau_S$, of a code sequence $C$, according to Eq. 2), based on another, already-sampled, reference sequence $R$ that represents the sampling of the same code $C$ but at sampling rate $f_R$ and initial phase $\tau_R$ (according to Eq. 3), assuming that $f_S \neq f_R$ and/or $\tau_S \neq \tau_R$ (at least one, or both, of these two parameters is expected to be different between the two sample sequences), with no need at all of knowing the underlaying code sequence $C$. Each of the involved sample sequences (reference or target) can be either oversync, subsync or sync, regardless of the other sequence (although, in practical terms, it would not make much sense that both sequences are sync).

The analysis presented above for a generic sequence X is applied now, separately, to both the reference and the target sequences, just by considering again the sequences $R$ and $S$, respectively, with the provision that, depending on its specific sampling rate, each sequence can correspond to any of the three cases: oversync, subsync or sync.

The method to build the target sequence then applies the proper equation (out of those from Eq. 5 or Eq. 7) to both the reference sequence $S$ and to the target sequence $R$, based on the respective sampling rates and initial phases.

In a most generic case, the integer number $M_X$ (which is the rounded ratio between the sampling rate of the desync sequence and the sampling rate of the corresponding sync sequence) may take different values for the reference sequence and for the target sequence, so that there may be one such number $M_X$ for the reference sequence $R$, i.e.

$M_R = round\left(\frac{f_R}{f_c}\right)$, and another for the target sequence S, i.e., $M_S = round\left(\frac{f_S}{f_c}\right)$. In other words, there may be two different sync sequences, one for the reference sequence and another for the target sequence.

If one of the sequences (reference or target) is of sync nature, the target sequence can be built just by following one of the above equations:

- In case that the reference sequence $R$ is a sync sequence (i.e., $R = V_0$, with $f_R = f_0 = M_S \cdot f_C$) and the target sequence $S$ is desync, then Eq. 6a or Eq. 6b directly allow building the target sequence $S$ based on the reference sequence $R$.
- If the reference sequence $R$ is desync and the target sequence $S$ *is* sync ($f_S = M_R \cdot f_C$), then Eq. 7b or Eq. 7d allow building the target sequence based on the reference sequence.

If both the reference and the target sequences are desync, a different approach is applied, but the main idea of the disclosure is still the same: the target sequence is built by concatenating intervals of samples from the reference sequence, profiting from the fact that the binary values (1 or 0) of the samples are shared by both sequences in those intervals between consecutive non-nominal sync samples.

In this case, both the reference and the target sequences have their corresponding non-nominal sync samples: some of these non-nominal samples may sometimes coincide between both sequences but, in a general case, they may be different. Therefore, it is necessary to account for all the non-nominal events (jointly from both the reference and the target sequences).

It is important to make clear that, although the non-nominal sync samples have been mentioned, the sync sequence is not needed at all in this case where the two sequences are desync: the sync sequence is deemed just as a virtual sequence (not really needed) that provides a common frame, a conceptual, mathematical link in order to cross-relate the reference sequence to the target sequence through their respective vectors of non-nominal indexes, since such indexes bear a meaning only with respect to the sync sequence.

In a general case, the reference and the target sequences are both desync, either oversync or subsync, depending on the relation of their sampling rate with the sampling rate of the sync sequence.

As previously indicated, no constraint is imposed in this respect and all combinations are possible: oversync reference sequence and oversync target sequence; oversync reference sequence and subsync target sequence; subsync reference sequence and oversync target sequence; or subsync reference sequence and subsync target sequence.

The link between the target sequence and the sync sequence is determined by the indexes within vector $[m_k]$, while the link between the reference sequence and the sync sequence is driven by the indexes within vector $[m'_e]$.

One possible approach proposed by this disclosure to deal with this case, when both the target and the reference sequences are desync, starts by creating a combined vector $[p_j]$ containing all the elements of vectors $[n'_e]$ and $[n_k]$, (i.e., those elements whose integer truncation yields the corresponding vectors of integer elements $[m'_e]$ and $[m_k]$), sorted in increasing order towards $\infty$:

$$[p_j] = sorted_{\to\infty}([n'_e], [n_k]), \text{ with } j = [0 \ldots (N_P - 1)], N_P = N_R + N_S$$

where $N_R$ and $N_S$ are the number of non-nominal events respectively for the reference and the target sequence.

Then, another vector $[q_j]$ is computed by integer truncation as follows:

$$[q_j] = trunc[p_j + \alpha_j \cdot \delta_j]$$

where:

- *trunc* is rounding towards $-\infty$ *(ceil)* if element $p_j$ is related to an oversync sequence, or towards $\infty$ *(floor)* if element $p_j$ is related to a subsync sequence.
- $\delta_j$ and $\alpha_j$ are two integer numbers, defined for each index $j$ as follows:

    o If the reference sequence and the target sequence are both oversync or both subsync, then $\delta_j = 0$.
    o If the reference sequence is from oversync and the target sequence is subsync, $\delta_j$ is the number of elements in the vector $[p_j]$ with indexes smaller than $j$ corresponding to the reference sequence and $\alpha_j = 1$.
    ◦ If the reference sequence is subsync and the target sequence is oversync, $\delta_j$ is the number of elements in the vector $[p_j]$ with indexes smaller than $j$ corresponding to the target sequence and $\alpha_j = -1$.

In order to build the target sequence from the reference sequence, vector $[q_j]$ is swept on all its elements in order to account for all the non-nominal events (coming either from the target or the reference sequences, both of them desync), implementing the required action for each, either duplicating or discarding samples, depending on the specific need:

- If a given element of vector $[q_j]$ is for the target sequence, duplicating or discarding the sample is consistent with either Eq. 6a or Eq. 6b, depending on whether the target sequence is oversync or subsync, respectively.

- If a given element of $[q_j]$ is for the reference sequence, duplicating or discarding the sample is consistent with either Eq. 7b or Eq. 7d, depending on whether the reference sequence is oversync or subsync, respectively.

In the particular case where the reference and the target sequences are desync and, in addition, share the same sampling rate ($f_R = f_S \neq f_0$, i.e., the difference between both sequences is related to the initial phase, not the sampling rate), vector $[q_j]$ is composed by elements related alternatively to the reference and the target sequences. Otherwise, vector $[q_j]$ contains more indexes related to the sequence (reference or target) that is farther from the sampling rate of the sync-sequence. If one of the sequences is sync, $[q_j]$ is composed just by indexes of non-nominal events from the other sequence and the method is simplified to the case of a single equation.

In case where both the reference and the target sequences are desync, many combinations are possible:

- If both sequences (reference and target) are desync in the same way (oversync or subsync):

   o If both sequences are oversync, then the non-nominal sync samples are in excess for both sequences (compared to the virtual sync sequence):

   - If a non-nominal event is only for the reference sequence, the corresponding reference sample is discarded (since it is not needed as target).
   - If a non-nominal event is only for the target sequence, the proper sample is included twice (because the target sequence needs one more).
   - If a non-nominal event appears on both sequences, no action is needed, since both sequences are consistent for that event.

   o If both sequences are subsync, then the non-nominal sync samples are in defect for both sequences (compared to the sync sequence):

   - If a non-nominal event is only for the reference sequence, the reference sequence lacks one sample compared to the target sequence, and the proper reference sample is duplicated.
   - If a non-nominal event is only for the target sequence, the corresponding sample in the reference sequence is not needed and is discarded.
   - If a non-nominal event appears on both sequences, no action is needed, since both sequences are consistent for that event.

- If both sequences are desync, but each in a different way:

   o If the reference sequence is oversync and the target sequence is subsync, the non-nominal events are in excess for the reference sequence and in defect for the target sequence:

   - If a non-nominal event is only for the reference sequence, the corresponding reference sample is discarded (since it is not needed as target).
   - If a non-nominal event is only for the target sequence, the corresponding sample in the reference sequence is not needed and is discarded.
   - If a non-nominal event appears on both sequences, two reference samples (the current and the previous one) are discarded.

   o If the reference sequence is subsync and the target sequence is oversync, the non-nominal events are in defect for the reference sequence and in excess for the target sequence:

   - If a non-nominal event is only for the reference sequence, the reference sequence lacks one sample compared to the target sequence, and the proper reference sample is duplicated.
   - If a non-nominal event is only for the target sequence, the proper reference sample is duplicated (because the target sequence needs one more).
   - If a non-nominal event appears on both sequences, the reference sample is duplicated twice.

The practical efficiency of the proposed method depends on the number of involved intervals, which in turn depends on the value of the sampling rates involved: the closer the sampling rates (of the reference and target sequences) to the sampling rate of the corresponding sync sequence, the fewer number of non-nominal events, the longer intervals of samples between non-nominal samples, and the better efficiency.

From the point of view of computational efficiency, the intervals of nominal samples (between consecutive non-nominal samples) should be, ideally, as long as possible. However, depending on the sampling features of the sequences involved, there may be intervals of samples that are in fact composed of single samples, i.e., there may be nominal samples that are preceded and followed by non-nominal samples.

The examples given so far consider sequences which are vectors composed of consecutive, single samples. However, the present disclosure is also applicable when the samples are packed in clusters of N samples per N-bit word, with each sample taking one bit (1 or 0) in the representation of the word. In this case, each index $m_k$ is split in a couple of figures, a first figure represents the word index, and the other figure corresponds to the bit index within the word. In addition, the method of taking intervals of samples from the packed reference sequence and concatenating them into the packed target sequence implies the use of bitwise operations (binary masking, bit shift, AND, OR, XOR, NOT...), which constitute standard and well-known mechanisms in signal processing.

The advantage of this disclosure is that it allows to build the target sequence $S$ by concatenating sets of samples taken from a pre-existent already-sampled sequence, the reference sequence $R$ (instead of from the code sequence), by taking care of managing the transitions between the sets by either duplicating or discarding one or more samples, according to the analytically derived pattern disclosed in the foregoing. This approach contrasts with the conventional method, where all the chips and all the samples must be swept to generate the target sequence.

In what follows, three examples are presented just for illustration purposes:

- The first two examples involve sequences composed of consecutive samples (also referred to as "linear sequences") and refer to cases where both the reference and the target sequences are desync. Therefore, both sets of vectors $[n_k]$ and $[n'_e]$ are computed to ultimately produce the combined vector $[q_j]$, which is the basis for the concatenation of the sets from the reference sequence to build the target sequence.
- The third example shows how to deal with packed sequences, where the samples are packed as bits within words.

Example 1: oversync reference sequence and subsync target sequence

An example is provided based on the (short) sequences shown in Figure 2, wherein two cases are presented, one for an oversync sequence (Fig. 2A) and another for a subsync sequence (Fig. 2B), both of them with $M = 3$, with sampling parameters defined by Eq. 4a and 4b.

The oversync sequence represented by diamonds in Fig. 2A, with sampling parameters from Eq. 4a, is defined in this example as reference sequence, $R$, and the subsync sequence also represented by diamonds in Fig. 2B, with sampling parameters from Eq. 4b, is assumed as target sequence S. The purpose is to obtain the target sequence S based on the available reference sequence $R$.

Specifically in this example, the sequences take the following values:

| Sample Index | 0 | 1 | 2 | 3 | 4 | 5 | 6 | 7 | 8 | 9 |
|---|---|---|---|---|---|---|---|---|---|---|
| *R:* Reference: oversync | 1 | 1 | 1 | 1 | 0 | 0 | 0 | 1 | 1 | 1 |
| *S:* Target: subsync | 1 | 1 | 1 | 0 | 0 | 1 | 1 | | | |

Since the reference sequence is oversync, the corresponding vector of non-nominal samples, $[m'_e]$, is computed based on Eq. 7a. In this case, with such a short example sequence, the vector contains a single non-nominal sample, after operating:

$$e = 0: [n'_0] = [3.8] \;\rightarrow\; [m'_0] = floor([n'_0]) = [3]$$

for the reference sequence.

Regarding the target sequence, being subsync, the vector of non-nominal samples, $[m_k]$, is computed through Eq. 5b, and also contains a single non-nominal sample:

$$k = 0: [n_0] = [4.63] \;\rightarrow\; [m_0] = ceil([n_0]) = [5]$$

for the target sequence.

Then, the real-number combined vector [$p_j$] has two elements (one from each sequence):

$$[p_j] = [3.8, 4.63]$$

and the integer-number combined vector [$q_j$] becomes:

$$[q_j] = [floor(p_0), ceil(p_1) + 1] = [3_R, 6_S]$$

where $p_0$ has been truncated downwards (using *floor*) and $p_1$ upwards (using *ceil*), consistently with the corresponding sequences being oversync and subsync, respectively, and with element $q_j$ (corresponding to a non-nominal event in the target sequence) being increased by 1 in order to account for the fact that there has been already a previous non-nominal event (sample excess) in the reference sequence. The subscripts $R$ and $S$ are added to indicate the underlying sequence (reference or target).

In this simple case, in order to build the target sequence from the reference sequence, just two non-nominal cases, $q_0 = 3_R$ and $q_1 = 6_S$, are to be analyzed. As the reference sequence is oversync and target sequence is subsync, all the non-nominal events from [$q_j$] imply discarding reference samples. The information of which sample needs to be discarded in each case is contained in vector [$q_j$].

As previously explained, each of these elements corresponds to a non-nominal sample in the virtual sync sequence (this sync sequence just being a conceptual, mathematical tool, which does not need to be available nor computed at all):

- $q_0 = 3_R$: this non-nominal event corresponds to a sample that is in excess in the reference sequence (as indicated by the subscript $R$), because of being oversync. Therefore, the sample with index $q_0 = 3$ in the reference sequence is discarded (valued 1).

- $q_1 = 6_S$: this non-nominal element corresponds to a sample that is missing in the target sequence (as indicated by the subscript $S$), because of being subsync. Therefore, the sample with index $q_1 = 6$ in the reference sequence is discarded (valued 0).

In summary, the target sequence is built by taking and concatenating sets of reference samples discarding (excluding) reference samples with indexes 3 and 6.

Example 2: subsync reference and oversync target

In this example, the subsync sequence represented by diamonds in Figure 2B is the reference sequence and the oversync sequence represented by diamonds in Figure 2A is the target sequence:

| Sample Index | 0 | 1 | 2 | 3 | 4 | 5 | 6 | 7 | 8 | 9 |
|---|---|---|---|---|---|---|---|---|---|---|
| $R$: Reference: subsync | 1 | 1 | 1 | 0 | 0 | 1 | 1 | 1 | | |
| $S$: Target: oversync | 1 | 1 | 1 | 1 | 0 | 0 | 0 | 1 | 1 | 1 |

Since the reference sequence is subsync, the corresponding vector of non-nominal samples, $[m'_e]$, is computed based on Eq. 7c. In this case, with such a short example sequence, the vector contains a single non-nominal sample, after operating:

$$e = 0: [n'_0] = [4.42] \ [m'_0] = ceil([n'_0]) = [5]$$

for the reference sequence.

Regarding the target sequence, being oversync, the vector of non-nominal samples, [$m_k$], is computed through Eq. 5a, and also contains a single non-nominal sample:

$$k = 0: [n_0] = [3.07] \rightarrow [m_0] = floor([n_0]) = [3]$$

for the target sequence.

Then, the real-number combined vector [$p_j$] has two elements (one from each sequence):

$$[p_j] = [3.07, 4.42]$$

and the integer-number combined vector [$q_j$] becomes:

$$[q_j] = [floor(p_0), ceil(p_1) - 1] = [3_S, 4_R]$$

where $p_0$ has been truncated downwards (using *floor*) and $p_1$ upwards (using *ceil*), consistently with the corresponding sequences being oversync and subsync, respectively, and with element $q_j$ (corresponding to a non-nominal event in the target sequence) being decreased by 1 in order to account for the fact that there has been already a previous non-nominal event (sample excess) in the target sequence. The subscripts $R$ and S are added to indicate the underlying sequence (reference or target).

In this simple case, in order to build the target sequence from the reference sequence, just two non-nominal cases, $q_0 = 3_S$ and $q_1 = 4_S$, are to be analyzed. As the reference sequence is subsync and target sequence is oversync, all the non-nominal events from [$q_j$] imply duplicating reference samples. The information of what sample needs to be duplicated in each case is contained in vector [$q_j$]. Notice that, in this case, it is necessary to consider the element $\Delta_k$, which may introduce a shift in the involved index.

As previously explained, each of these elements corresponds to a non-nominal sample in the virtual sync sequence (this sync sequence just being a conceptual, mathematical tool, which does not need to be available nor computed at all):

- $q_0 = 3_S$: this non-nominal event corresponds to a sample that is in excess in the target sequence, because of being oversync. Since *modulus*(3,3) =0, $\Delta_0$= 1, the reference sample with index $q_0$ - $\Delta_0$= 3 - 1 = 2 is duplicated (valued 1).

- $q_1 = 4_1$: this non-nominal event corresponds to a sample that is missing in the reference sequence, because of being subsync. Since *modulus*(4,3) $\neq$ 0, $\Delta_0$= 0. Therefore, the reference sample with index 4 - 0 = 4 is duplicated (valued 0).

In summary, the target sequence is built by taking and concatenating sets from the reference samples, inserting (duplicating) reference samples with indexes 2 and 4.

<u>Example with packed samples</u>

So far, the description and examples given have been based on linear vector samples, i.e., the sequence is composed of consecutive single elements. But, as previously mentioned, the method proposed is also fully applicable to the case of packed samples, in which the binary values of the samples are denoted by the bits that define the binary representation of integer words. Packing can be based on words of different lengths, with a number of bits, $N_{bits}$, usually being a power of 2: $N_{bits}$ = 4,8,16,35,64 ... depending on the design approach and the features of the hosting processor.

Packed processing is a well-known topic within the signal-processing community and does not require to be covered in detail here. Nevertheless, a simple example is provided just for illustrative purposes.

As in Example 1, the oversync sequence represented by diamonds in Figure 2A is the reference sequence, $V_{S1}$, and the subsync sequence also represented by diamonds in Figure 2B is the target sequence $V_{S2}$. For the sake of simplicity, $N_{bits}$ = 4 bits per word is used for packing (although in practice, most processors usually deal with 32-bit words).

| Word | 0 | 1 | 2 | |
|---|---|---|---|---|
| *R:* Reference | [1111]=15 | [0001]=1 | [11XX]=12 | |
| *S:* Target | [1110]=14 | [0111]=7 | - | |

The third word of the reference sequence is incomplete and only the two MSBs are used, assuming arbitrarily that XX = [00], thus taking value 12.

With this packed approach, the index vector of the non-nominal events, [Q] (using capital letters to denote packing), take the format of two numbers per event: one to represent the word (*W*) and another to represent the bit within that word (*B*):

$$[Q] \equiv [(W,B)_X]$$

where $X = R$ or $S$ identifies the sequence (reference or target).

For every non-nominal index $k$, each linear element of $Q_k$ is related to the corresponding pair $(W_k, B_k)_X$:

$$p_k = W_k \times N_{bits} + B_k$$

In this example, $[Q] = [3_R, 5_S]$. Therefore:

$$[Q] \equiv [(0,3)_R, (1,2)_S]$$

All the reasoning from Example 1 is applicable here, so that samples number 3 and 6 are discarded from the reference sequence in order to build the target sequence. Being packed, the method uses binary operations working on the words. Discarding a sample (i.e., a bit from a word) implies masking the involved bit and shifting leftward one position all the bits (from all the words) rightwards.

For example, discarding sample number 3 from the first word:

$$(W_0)_S = [(W_0)_R \& mask_R]|([(W_0)_R \& mask_S] \gg 3) = [15\&14]|([1\&8] \gg 3) = 14$$

$mask_R = 14$ and $mask_S = 8$ are used as masks to select the required bits;
& represents binary *AND*;
| corresponds to binary OR;
» stands for binary shift to the right.

The method continues for all required non-nominal events and all the words, in order to build the target sequence.

The present disclosure has specific application in GNSS systems, which make use of spread-spectrum modulations, where the signals transmitted by the satellites are based on sequences of PRN codes, known to both the transmitter and the receiver.

In a specific application of the present disclosure, the original code sequence are the PRN codes. Most of the GNSS signals are based on periodic PRN codes. Each PRN code is characterized by the chip rate (number of chips per second) and code length (number of chips in a periodic code before repetition). For example, for GPS C/A signal, the chip rate is 1.023 Mchips/s and the code length 1023 chips (or, equivalently in time, 1 ms).

Typically, there is a particular constraint that affects the choice of the sampling frequency for GNSS receivers, since it is recommended that the sampling frequency is not an exact integer multiple of the chip rate. If the sampling frequency were an exact integer multiple, the generated PRN code may not show the effect of the specific code phase.

The method disclosed herein provides a novel and efficient mechanism for providing the receiver with the required sets of sampled PRN vectors, to be used as replicas for the receiver processing.

In this text, the term "includes", "comprises" and derivations thereof (such as "including", "comprising", etc.) should not be understood in an excluding sense, that is, these terms should not be interpreted as excluding the possibility that what is described and defined may include further elements, steps, etc. On the other hand, the disclosure is obviously not limited to the specific embodiments or examples described herein, but also encompasses any variations that may be considered by any person skilled in the art within the general scope of the invention as defined in the claims.

**Claims**

1. A computer implemented method for building a target sequence $S$ of binary samples from a reference sequence $R$, the target sequence S of binary samples representing a sampling at a sampling rate $f_S$, a sampling period $T_S = \dfrac{1}{fs}$ and an initial phase $\tau_S$ of a code sequence $C$ of $N_C$ binary chips at chip rate $f_C$ and chip period $T_C = \dfrac{1}{fc}$ ,

the reference sequence R = $[r_{(0)} \dots r_{(LR}\text{-}1)]$ being a sampled sequence of the code sequence $C$ at a sampling rate $f_R$, $f_R > f_C$, having a sampling period $T_R = \dfrac{1}{f_R}$ and an initial phase $\tau_R$, each sample $r_{(i)}$ of the reference sequence having an index $i$ belonging to the interval $[0, (L_R - 1)]$, wherein either $f_S \neq f_R$ and/or $\tau_S \neq \tau_R$, and wherein the reference sequence R is available in advance, and the target sequence S to be built is not available in advance, but is **characterized by** its sampling frequency $f_S$ and initial phase $\tau_S$, and wherein $f_S$, $f_R$, $\tau_S$ and $\tau_R$ are used to mathematically compute a vector of values of indexes of samples in the reference sequence $R$, these indexes being boundary indexes which are used for delimiting consecutive sets of samples in the reference sequence $R$, wherein the target sequence S is built by taking and placing said consecutive sets of samples and by, at the transition between said sets, either duplicating or discarding at least one sample of the reference sequence $R$ with the corresponding boundary index; the target sequence S being used as sampled PRN vector, to be used as replica for spread-spectrum modulation.

2. The method of claim 1, wherein the sampling rate $f_R$ of the reference sequence $R$ is an integer multiple of the chip rate $f_C$, where $f_R = M_S \cdot f_C$, being $M_S = round\left(\frac{f_S}{f_C}\right)$ and $M_S > 1$, with $f_S$ being the sampling rate of the target sequence,

wherein each set of samples of the reference sequence R is delimited by samples having indexes $i$, defined within the reference sequence, given by each couple of two consecutive elements from a first vector $[m_k]$, with $k = [0 \ldots (N_S - 1)]$, wherein the first vector $[m_k]$ is defined as follows:

• if

$$f_S > f_R:$$

$$N_S = ceil[f_S \cdot N_C \cdot M_S \cdot (T_R - T_S)],$$

$$[n_k] = \left[\frac{(k+1)\cdot T_R - (T_S - \tau_S)}{T_R - T_S} - k\right], \qquad [m_k] = floor([n_k]),$$

• if

$$f_S < f_R:$$

$$N_S = ceil[f_S \cdot N_C \cdot M_S \cdot (T_S - T_R)],$$

$$[n_k] = \left[\frac{(k+1)\cdot T_R - \tau_S}{T_S - T_R} + k\right], \quad [m_k] = ceil([n_k]),$$

where *floor* and *ceil* represent integer rounding towards $-\infty$ and $\infty$, respectively, and wherein the target sequence S is computed as follows:

• if

$$f_S > f_R$$

$$S = \begin{bmatrix} r_{(0)} \cdots r_{(m_0)}, r_{(m_0)}, r_{(m_0+1)} \cdots r_{(m_1)}, r_{(m_1)}, r_{(m_1+1)} \cdots \\ , \ldots r_{\left(m_{(N_S-1)}\right)}, r_{\left(m_{(N_S-1)}\right)}, r_{\left(m_{(N_S-1)}+1\right)} \cdots r_{(L_R-1)} \end{bmatrix}$$

where samples $r_{(mk)}$ with indexes $i = m_k$ from the first vector $[m_k]$, said samples defined within the reference sequence, are duplicated when building the target sequence,

• if

$$f_S < f_R:$$

$$S = \begin{bmatrix} r_{(0)}, \dots, r_{(m_0-1)}, r_{(m_0+1)} \cdots r_{(m_1-1)}, r_{(m_1+1)}, \cdots \\ , \dots r_{(m_{(N_S-1)}-1)}, r_{(m_{(N_S-1)}+1)}, \dots, r_{(L_R-1)} \end{bmatrix}$$

where reference samples $r_{(mk)}$ with indexes $i = m_k$ from the first vector $[m_k]$ are discarded when building the target sequence.

3. The method of claim 1, wherein the sampling rate $f_S$ of the target sequence S is an integer multiple of the chip rate $f_C$, where $f_S = M_R \cdot f_C$, being $M_R = round(\frac{f_R}{f_C})$ and $M_R > 1$,

with $f_R$ being the sampling rate of the reference sequence,
wherein each set of samples of the reference sequence R is delimited by samples having indexes $i$, defined within the reference sequence, given by each couple of two consecutive elements from a second vector $[m'_e]$, with e = [0 ... $N_R$ - 1], wherein the second vector $[m'_e]$ is defined as follows:

• if

$$f_S < f_R:$$

$$N_R = ceil[f_R \cdot N_C \cdot M_R \cdot (T_S - T_R)],$$

$$[n'_e] = \left[ \frac{(e+1) \cdot T_S - (T_R - \tau_R)}{T_S - T_R} - 1 \right], \ [m'_e] = floor([n'_e])$$

• if

$$f_S > f_R:$$

$$N_R = ceil[f_R \cdot N_C \cdot M_R \cdot (T_R - T_S)]$$

$$[n'_e] = \left[ \frac{(e+1) \cdot T_S - \tau_R}{T_R - T_S} + 1 \right], \ [m'_e] = ceil([n'_e])$$

where *floor* and *ceil* represent integer rounding towards -∞ and ∞, respectively, and wherein the target sequence S is computed as follows:
• if

$$f_S < f_R:$$

$$S = \begin{bmatrix} r_{(0)}, \dots, r_{(m'_0-1)}, r_{(m'_0+1)}, \dots, r_{(m'_1-1)}, r_{(m'_1+1)}, \cdots \\ , \dots, r_{(m'_{(N_R-1)}-1)}, r_{(m'_{(N_R-1)}+1)}, \dots, r_{(L_R-1)} \end{bmatrix}$$

where samples $r_{(m'_e)}$, with indexes $i = m'_e$ from the second vector $[m'_e]$ are discarded when building the target sequence,

• if

$$f_S > f_R:$$

$$S = \begin{bmatrix} r_{(0)} \cdots r_{(m'_0)}, r_{(m'_0 - \Delta_0)}, r_{(m'_0 + 1)} \cdots r_{(m'_1)}, r_{(m'_1 - \Delta_1)}, r_{(m'_1 + 1)} \cdots \\ \cdots, r_{(m'_{(N_R - 1)})}, r_{(m'_{(N_R - 1)} - \Delta_{(N_R - 1)})}, r_{(m'_{(N_R - 1)} + 1)}, r_{(L_R - 1)} \end{bmatrix}$$

where samples $r_{(m'_e)}$ with indexes $i = m'_e$ from the second vector $[m'_e]$ are duplicated when building the target sequence,
and wherein $\Delta_e$ is:

if

$$modulus(m'_e, M_R) = 0 \Rightarrow \Delta_e = 1$$

if

$$modulus(m'_e, M_R) \neq 0 \Rightarrow \Delta_e = 0.$$

**4.** The method of claim 1, wherein each set of samples of the reference sequence R is delimited by samples having indexes given by each couple of two consecutive elements from a vector [$q_j$], the vector [$q_j$] being computed as rounding of the elements of another vector [$p_j$] computed by combining elements from a first vector [$n_k$] and elements of a second vector $[n'_e]$,

wherein the first vector [$n_k$] with $k$ = [0 ... $N_S$ - 1)] is defined for the target sequence S as follows:

a) if

$$f_S > M_S \cdot f_C:$$

$$N_S = ceil[f_S \cdot N_C \cdot M_S \cdot (T'_S - T_S)], [n_k] = \left[ \frac{(k+1) \cdot T'_S - (T_S - \tau_S)}{T'_S - T_S} - k \right],$$

b)

$$f_S < M_S \cdot f_C:$$

$$N_S = ceil[f_S \cdot N_C \cdot M_S \cdot (T_S - T'_S)], \quad [n_k] = \left[ \frac{(k+1) \cdot T'_S - \tau_S}{T_S - T'_S} + k \right]$$

where $M_S$ is a number $M_S = round\left(\frac{f_S}{f_C}\right)$, $M_S$ > 1, and $T'_S = \frac{1}{M_S \cdot f_C}$,

wherein the second vector $[n'_e]$ with $e$ = [0 ... ($N_R$ - 1)] is defined for the reference sequence $R$ as follows:

c) if

$$f_R > M_R \cdot f_C:$$

$$N_R = ceil[f_R \cdot N_C \cdot M_R \cdot (T_R' - T_R)] \;, \qquad [n_e'] = \left[\frac{(e+1)\cdot T_R' - (T_R - \tau_R)}{T_R' - T_R}\right]$$

d) if

$$f_R < M_R \cdot f_C:$$

$$N_R = ceil[f_R \cdot N_C \cdot M_R \cdot (T_R - T_R')] \;, \; [n_e'] = \left[\frac{(e+1)\cdot T_R' - \tau_R}{T_R - T_R'}\right]$$

where $M_R$ is a number $M_R = round\left(\frac{f_R}{f_C}\right)$, $M_R > 1$, and $T_R' = \frac{1}{M_R \cdot f_C}$,

wherein the elements in $[p_j]$ are sorted in increasing order, where each element $q_j$ is computed by rounding the corresponding element $p_j$.

**5.** The method of claim 4, wherein each element $q_j$ is computed by rounding the corresponding element $p_j$ as follows:

$$[q_j] = trunc[p_j + \alpha_j \cdot \delta_j]$$

where:

• *trunc* is rounding towards -∞ if element $p_j$ is related to a sequence following any of cases a) or c) above, or towards ∞ if element $p_j$ is related to a sequence following any of cases b) or d) above,
• $\delta_j$ and $\alpha_j$ are two integer numbers, defined for each index $j$ as follows:

    o if the reference sequence and the target sequence are from cases a) or c), $\delta_j = 0$,
    o if the reference sequence and the target sequence are from cases b) or d), $\delta_j = 0$,
    o if the reference sequence is from cases a) or c) and the target sequence is from cases b) or d), $\delta_j$ is the number of elements in the vector $[p_j]$ with indexes smaller than $j$ corresponding to the reference sequence and $\alpha_j = 1$,
    o if the reference sequence is from cases b) or d) and the target sequence is from cases a) or c), $\delta_j$ is the number of elements in the vector $[p_j]$ with indexes smaller than $j$ corresponding to the target sequence and $\alpha_j = -1$,

wherein the target sequence is built by concatenating the sets of samples from the reference sequence delimited by consecutive couples of elements of vector $[q_j]$, and where, for each set, at least one sample is either duplicated if the given element $q_j$ corresponds to a sequence from cases a) or c), or discarded if the given element $q_j$ corresponds to a sequence from cases b) or d),
and where, when for a given element $q_j$, a reference sample is to be duplicated, the index of the reference sample to be duplicated is:

• $q_j$ if

$$modulus\left(q_j, M_R\right) \neq 0 \;,$$

• $q_j$ - 1 if

$$modulus\left(q_j, M_R\right) = 0,$$

and where, when for a given element $q_j$, a reference sample is to be discarded, the index of the reference sample to be discarded is given by the element $q_j$.

6. The method of any one of claims 2-3, wherein the reference sequence and/or the target sequence are/is packed in sets of words, each word being composed of N bits, wherein each element of the first vector $[m_k]$ and/or the second vector $[m_k']$ is represented by a first number and a second number, the first number corresponding to a word index and the second number indicating a bit index within the corresponding word.

7. The method of claim 4, wherein the reference sequence and/or the target sequence are/is packed in sets of words, each word being composed of $N$ bits,
wherein each element of the first vector $[n_k]$ and of the second vector $[n_e']$ is represented by a first number and a second number, the first number corresponding to a word index and the second number indicating a bit index within the corresponding word.

8. The method of any of claims 6-7, wherein the step of duplicating and/or discarding samples from the reference sequence in order to build the target sequence, is carried out by using bitwise operations.

9. The method of any one of claims 1-8, wherein the sampling rate $f_R$ of the reference sequence and/or the sampling rate $f_S$ of the target sequence are/is time variable, and are/is expressed, for a given time $t$, in terms of time derivatives, $\dot{f}_x$, $\ddot{f}_x,...$ of the corresponding sampling rate $f_x$ with $x$ = 1 *or* 2, as follows:

$$f_x(t) = f_{x,0} + \dot{f}_x \cdot t + \frac{1}{2} \cdot \ddot{f}_x \cdot t^2 + \cdots.$$

10. A signal-processing device, comprising:

at least one processor; and
at least one memory;
wherein the at least one memory is configured, together with the at least one processor, to cause the signal-processing device to carry out the steps of a method according to any one of claims 1-9.

11. The signal-processing device of claim 10, wherein the signal-processing device is a GNSS receiver.

12. A computer program comprising instructions which, when the program is executed by a computing device, cause the computing device to carry out the steps of a method according to any one of claims 1-9.

**Patentansprüche**

1. Computerimplementiertes Verfahren zum Erstellen einer Zielsequenz $S$ binärer Muster aus einer Referenzsequenz $R$, wobei die Zielsequenz $S$ binärer Muster eine Abtastung mit einer Abtastrate $f_S$, einer Abtastperiode $T_S = \frac{1}{f_S}$ und einer Anfangsphase $\tau_S$ einer Codesequenz $C$ von $N_C$ binärer Chips mit Chiprate $f_C$ und Chipperiode $T_C = \frac{1}{f_C}$,

die Referenzsequenz $R = [r_{(0)} ... r_{(LR}\text{-}1)]$ eine abgetastete Sequenz der Codesequenz $C$ mit einer Abtastrate $f_R$, $f_R$ > $f_C$ ist, mit einer Abtastperiode $T_R = \frac{1}{f_R}$ und einer Anfangsphase $\tau_R$, wobei jedes Muster $r_{(i)}$ der Referenzsequenz einen Index $i$ aufweist, der zum Intervall [0, $(L_R$ - 1)] gehört, wobei entweder $f_S \neq f_R$ und/oder $\tau_S \neq \tau_R$ gilt, und
wobei die Referenzsequenz $R$ im Voraus verfügbar ist, und die Zielsequenz $S$, die zu erstellen ist, nicht im Voraus verfügbar ist, sondern durch ihre Abtastfrequenz $f_S$ und Anfangsphase $\tau_S$ gekennzeichnet ist, und
wobei $f_S$, $f_R$, $\tau_S$ und $\tau_R$ verwendet werden, um mathematisch einen Vektor von Werten von Mustern in der Referenzsequenz $R$ zu berechnen, wobei diese Indizes Grenzindizes sind, die zur Abgrenzung aufeinanderfolgender Sätze von Mustern in der Referenzsequenz $R$ verwendet werden,
wobei die Zielsequenz $S$ erstellt wird, indem die genannten aufeinanderfolgenden Sätze von Mustern genommen und platziert werden und beim Übergang zwischen den genannten Sätzen mindestens ein Muster der Referenzsequenz $R$ mit dem entsprechenden Grenzindex entweder dupliziert oder verworfen wird;

wobei die Zielsequenz $S$ als abgetasteter PRN-Vektor verwendet wird, um als Replik für die Spreizspektrum-Modulation verwendet zu werden.

2. Verfahren nach Anspruch 1, wobei die Abtastrate $f_R$ der Referenzsequenz $R$ ein ganzzahliges Vielfaches der Chiprate $f_C$ ist, wobei $f_R = M_S \cdot f_C$, mit $M_S = round\left(\dfrac{f_S}{f_C}\right)$ und $M_S > 1$, wobei $f_S$ die Abtastrate der Zielsequenz ist,

wobei jeder Satz von Mustern der Referenzsequenz $R$ durch Muster mit Indizes $i$ begrenzt wird, die innerhalb der Referenzsequenz definiert sind und durch jedes Paar von zwei aufeinanderfolgenden Elementen aus einem ersten Vektor $[m_k]$ mit $k = [0 \ldots (N_S - 1)]$ gegeben sind, wobei der erste Vektor $[m_k]$ wie folgt definiert ist:

- wenn

$$f_S > f_R :$$

$$N_S = ceil[f_S \cdot N_C \cdot M_S \cdot (T_R - T_S)],$$

$$[n_k] = \left[\frac{(k+1)\cdot T_R - (T_S - \tau_S)}{T_R - T_S} - k\right], \qquad [m_k] = floor([n_k]),$$

- wenn

$$f_S < f_R :$$

$$N_S = ceil[f_S \cdot N_C \cdot M_S \cdot (T_S - T_R)],$$

$$[n_k] = \left[\frac{(k+1)\cdot T_R - \tau_S}{T_S - T_R} + k\right], \quad [m_k] = ceil([n_k]),$$

wobei *floor* und *ceil* eine ganzzahlige Rundung gegen -∞ und ∞ darstellen, und
wobei die Zielsequenz $S$ wie folgt berechnet wird:

- wenn

$$f_S > f_R$$

$$S = \begin{bmatrix} r_{(0)} \cdots r_{(m_0)}, r_{(m_0)}, r_{(m_0+1)} \cdots r_{(m_1)}, r_{(m_1)}, r_{(m_1+1)} \cdots \\ , \ldots r_{\left(m_{(N_S-1)}\right)}, r_{\left(m_{(N_S-1)}\right)}, r_{\left(m_{(N_S-1)}+1\right)} \cdots r_{(L_R-1)} \end{bmatrix}$$

wobei Muster $r_{(mk)}$ mit Indizes $i = m_k$ aus dem ersten Vektor $[m_k]$ beim Erstellen der Zielsequenz dupliziert werden, wobei die genannten Muster innerhalb der Referenzsequenz definiert sind,

- wenn

$$f_S < f_R :$$

$$S = \begin{bmatrix} r_{(0)}, \ldots, r_{(m_0-1)}, r_{(m_0+1)} \cdots r_{(m_1-1)}, r_{(m_1+1)}, \cdots \\ , \ldots r_{(m_{(N_S-1)}-1)}, r_{(m_{(N_S-1)}+1)}, \ldots, r_{(L_R-1)} \end{bmatrix}$$

wobei Referenzmuster $r_{(mk)}$ mit Indizes $i = m_k$ aus dem ersten Vektor $[m_k]$ beim Erstellen der Zielsequenz verworfen werden.

3. Verfahren nach Anspruch 1, wobei die Abtastrate $f_S$ der Zielsequenz $S$ *ein* ganzzahliges Vielfaches der Chiprate $f_C$ ist, wobei $f_S = M_R \cdot f_C$, mit $M_R = round(\frac{f_R}{f_C})$ und $M_R > 1$, wobei $f_R$ die Abtastrate der Referenzsequenz ist,

wobei jeder Satz von Mustern der Referenzsequenz $R$ durch Muster mit Indizes $i$ begrenzt wird, die innerhalb der Referenzsequenz definiert sind und durch jedes Paar von zwei aufeinanderfolgenden Elementen aus einem zweiten Vektor $[m'_e]$ mit $e = [0 \dots N_R - 1]$ gegeben sind, wobei der zweite Vektor $[m'_e]$ wie folgt definiert ist:

- wenn

$$f_S < f_R :$$

$$N_R = ceil[f_R \cdot N_C \cdot M_R \cdot (T_S - T_R)], \qquad [n'_e] =$$

$$\left[ \frac{(e+1) \cdot T_S - (T_R - \tau_R)}{T_S - T_R} - 1 \right] \ , \ [m'_e] = floor([n'_e])$$

- wenn

$$f_S > f_R :$$

$$N_R = ceil[f_R \cdot N_C \cdot M_R \cdot (T_R - T_S)]$$

wobei *floor* und *ceil* eine ganzzahlige Rundung gegen $-\infty$ und $\infty$ darstellen, und wobei die Zielsequenz $S$ wie folgt berechnet wird:

- wenn

$$f_S < f_R :$$

$$S = \left[ \begin{matrix} r_{(0)}, \dots, r_{(m'_0 - 1)}, r_{(m'_0 + 1)}, \dots, r_{(m'_1 - 1)}, r_{(m'_1 + 1)}, \dots \\ , \dots, r_{(m'_{(N_R - 1)} - 1)}, r_{(m'_{(N_R - 1)} + 1)}, \dots, r_{(L_R - 1)} \end{matrix} \right]$$

wobei Muster $r_{(m'_e)}$, mit Indizes $i = m'_e$ aus dem zweiten Vektor $[m'_e]$ beim Erstellen der Zielsequenz verworfen werden,

- wenn

$$f_S > f_R :$$

$$S = \left[ \begin{matrix} r_{(0)} \dots r_{(m'_0)}, r_{(m'_0 - \Delta_0)}, r_{(m'_0 + 1)} \dots r_{(m'_1)}, r_{(m'_1 - \Delta_1)}, r_{(m'_1 + 1)} \dots \\ \dots, r_{(m'_{(N_R - 1)})}, r_{(m'_{(N_R - 1)} - \Delta_{(N_R - 1)})}, r_{(m'_{(N_R - 1)} + 1)}, r_{(L_R - 1)} \end{matrix} \right]$$

wobei Muster $r_{(m'_e)}$ mit Indizes $i = m'_e$ aus dem zweiten Vektor $[m'_e]$ beim Erstellen der Zielsequenz dupliziert werden,

und wobei $\Delta_e$ ist:

if

$$modulus(m_e', M_R) = 0 \Rightarrow \Delta_e = 1$$

if

$$modulus(m_e', M_R) \neq 0 \Rightarrow \Delta_e = 0.$$

4. Verfahren nach Anspruch 1, wobei jeder Satz von Mustern der Referenzsequenz $R$ durch Muster mit Indizes begrenzt wird, die durch jedes Paar von zwei aufeinanderfolgenden Elementen aus einem Vektor $[q_j]$ gegeben sind, wobei der Vektor $[q_j]$ durch Rundung der Elemente eines weiteren Vektors $[p_j]$ berechnet wird, der durch Kombinieren von Elementen aus einem ersten Vektor $[n_k]$ und Elementen eines zweiten Vektors $[n_e']$ berechnet wird,

wobei der erste Vektor $[n_k]$ mit $k = [0 ... N_S - 1)]$ für die *ZielsequenzS* wie folgt definiert ist:

a) wenn

$$f_S > M_S \cdot f_C :$$

$$N_S = ceil[f_S \cdot N_C \cdot M_S \cdot (T_S' - T_S)], [n_k] = \left[ \frac{(k+1)\cdot T_S' - (T_S - \tau_S)}{T_S' - T_S} - k \right],$$

b)

$$f_S < M_S \cdot f_C :$$

$$N_S = ceil[f_S \cdot N_C \cdot M_S \cdot (T_S - T_S')] \quad , \quad [n_k] = \left[ \frac{(k+1)\cdot T_S' - \tau_S}{T_S - T_S'} + k \right]$$

wobei $M_S$ eine Zahl ist mit $M_S = round\left(\frac{f_S}{f_C}\right)$ und $M_S > 1$, wobei $T_S' = \frac{1}{M_S \cdot f_C}$ gilt,

wobei der zweite Vektor $[n_e']$ mit $e = [0 ... (N_R - 1)]$ für die Referenzsequenz R wie folgt definiert ist:

c) wenn

$$f_R > M_R \cdot f_C :$$

$$N_R = ceil[f_R \cdot N_C \cdot M_R \cdot (T_R' - T_R)] \quad , \quad [n_e'] = \left[ \frac{(e+1)\cdot T_R' - (T_R - \tau_R)}{T_R' - T_R} \right]$$

d) wenn

$$f_R < M_R \cdot f_C :$$

$$N_R = ceil[f_R \cdot N_C \cdot M_R \cdot (T_R - T_R')] \quad , \quad [n_e'] = \left[ \frac{(e+1)\cdot T_R' - \tau_R}{T_R - T_R'} \right]$$

wobei $M_R$ eine Zahl ist mit $M_R = round\left(\dfrac{f_R}{f_C}\right)$ und $M_R > 1$, wobei $T'_R = \dfrac{1}{M_R \cdot f_C}$ gilt,

wobei die Elemente in $[p_j]$ in aufsteigender Reihenfolge sortiert sind, wobei jedes Element $q_j$ durch Rundung des entsprechenden Elements $p_j$ berechnet wird.

**5.** Verfahren nach Anspruch 4, wobei jedes Element $q_j$ durch Rundung des entsprechenden Elements $p_j$ wie folgt berechnet wird:

$$[q_j] = trunc[p_j + \alpha_j \cdot \delta_j]$$

wobei:

- ***trunc*** eine Rundung gegen $-\infty$ ist, wenn das Element $p_j$ sich auf eine Sequenz bezieht, die einem der Fälle a) oder c) oben folgt, oder gegen $\infty$, wenn das Element $p_j$ sich auf eine Sequenz bezieht, die einem der Fälle b) oder d) oben folgt,
- $\delta_j$ und $\alpha_j$ zwei ganze Zahlen sind, die für jeden Index $j$ wie folgt definiert sind:

  ○ wenn die Referenzsequenz und die Zielsequenz aus den Fällen a) oder c) stammen, $\delta_j = 0$,
  ○ wenn die Referenzsequenz und die Zielsequenz aus den Fällen b) oder d) stammen, $\delta_j = 0$,
  ○ wenn die Referenzsequenz aus den Fällen a) oder c) stammt und die Zielsequenz aus den Fällen b) oder d) stammt, $\delta_j$ die Anzahl der Elemente im Vektor $[p_j]$ mit Indizes kleiner als $j$ ist, die der Referenzsequenz entsprechen, und $\alpha_j = 1$,
  ○ wenn die Referenzsequenz aus den Fällen b) oder d) stammt und die Zielsequenz aus den Fällen a) oder c) stammt, $\delta_j$ die Anzahl der Elemente im Vektor $[p_j]$ mit Indizes kleiner als $j$ ist, die der Zielsequenz entsprechen, und $\alpha_j = -1$,

  wobei die Zielsequenz durch Verketten der Sätze von Mustern aus der Referenzsequenz erstellt wird, die durch aufeinanderfolgende Paare von Elementen des Vektors $[q_j]$ begrenzt sind, und wobei für jeden Satz mindestens ein Muster entweder dupliziert wird, wenn das gegebene Element $q_j$ einer Sequenz aus den Fällen a) oder c) entspricht, oder verworfen wird, wenn das gegebene Element $q_j$ einer Sequenz aus den Fällen b) oder d) entspricht,
  und wobei, wenn für ein gegebenes Element $q_j$ ein Referenzmuster zu duplizieren ist, der Index des zu duplizierenden Referenzmusters ist:

  - $q_j$ wenn

$$modulus\left(q_j, M_R\right) \neq 0 \quad,$$

  - $q_j$ - 1 wenn

$$modulus\left(q_j, M_R\right) = 0,$$

  und wobei, wenn für ein gegebenes Element $q_j$ ein Referenzmuster zu verwerfen ist, der Index des zu verwerfenden Referenzmusters durch das Element $q_j$ gegeben ist.

**6.** Verfahren nach einem der Ansprüche 2-3, wobei die Referenzsequenz und/oder die Zielsequenz in Sätze von Wörtern gepackt ist/sind, wobei jedes Wort zusammengesetzt ist aus $N$ Bits, wobei jedes Element des ersten Vektors $[m_k]$ und/oder des zweiten Vektors $[m'_k]$ durch eine erste Zahl und eine zweite Zahl dargestellt wird, wobei die erste Zahl einem Wortindex entspricht und die zweite Zahl einen Bitindex innerhalb des entsprechenden Wortes angibt.

**7.** Verfahren nach Anspruch 4, wobei die Referenzsequenz und/oder die Zielsequenz in Sätze von Wörtern gepackt ist/sind, wobei jedes Wort zusammengesetzt ist aus $N$ Bits, wobei jedes Element des ersten Vektors $[n_k]$ und des

zweiten Vektors $\left[n'_e\right]$ durch eine erste Zahl und eine zweite Zahl dargestellt wird, wobei die erste Zahl einem Wortindex entspricht und die zweite Zahl einen Bitindex innerhalb des entsprechenden Wortes angibt.

8. Verfahren nach einem der Ansprüche 6-7, wobei der Schritt des Duplizierens und/oder Verwerfens von Mustern aus der Referenzsequenz zum Erstellen der Zielsequenz durch Verwendung bitweiser Operationen durchgeführt wird.

9. Verfahren nach einem der Ansprüche 1-8, wobei die Abtastrate $f_R$ der Referenzsequenz und/oder die Abtastrate $f_S$ der Zielsequenz zeitlich variabel ist/sind und für eine gegebene Zeit $t$ in Form von Zeitableitungen $\dot{f}_x, \ddot{f}_x, ...$ der entsprechenden Abtastrate $f_x$ mit $x = 1$ *or* $2$ wie folgt ausgedrückt wird/werden:

$$f_x(t) = f_{x,0} + \dot{f}_x \cdot t + \frac{1}{2} \cdot \ddot{f}_x \cdot t^2 + \cdots.$$

10. Signalverarbeitungsvorrichtung, umfassend:

mindestens einen Prozessor; und
mindestens einen Speicher;
wobei der mindestens eine Speicher zusammen mit dem mindestens einen Prozessor konfiguriert ist, die Signalverarbeitungsvorrichtung zu veranlassen, die Schritte eines Verfahrens nach einem der Ansprüche 1-9 auszuführen.

11. Signalverarbeitungsvorrichtung nach Anspruch 10, wobei die Signalverarbeitungsvorrichtung ein GNSS-Empfänger ist.

12. Computerprogramm, umfassend Anweisungen, die, wenn das Programm von einer Rechenvorrichtung ausgeführt wird, die Rechenvorrichtung veranlassen, die Schritte eines Verfahrens nach einem der Ansprüche 1-9 auszuführen.


**Revendications**

1. Procédé mis en oeuvre par ordinateur pour construire une séquence cible $S$ d'échantillons binaires à partir d'une séquence de référence $R$, la séquence cible $S$ d'échantillons binaires représentant un échantillonnage à une fréquence d'échantillonnage $f_S$, une période d'échantillonnage $T_S = \frac{1}{f_S}$ et une phase initiale $\tau_S$ d'une séquence de code $C$ de $N_C$ chips binaires à un débit chip $f_C$ et une période chip $T_C = \frac{1}{f_C}$,

la séquence de référence $R = [r_{(0)} \dots r_{(L_R-1)}]$ étant une séquence échantillonnée de la séquence de code $C$ à une fréquence d'échantillonnage $f_R$, $f_R > f_C$, ayant une période d'échantillonnage $T_R = \frac{1}{f_R}$ et une phase initiale $\tau_R$, chaque échantillon $r_{(i)}$ de la séquence de référence ayant un indice $i$ appartenant à l'intervalle [0, $(L_R - 1)$], dans laquelle soit $f_S \neq f_R$ et/ou $\tau_S \neq \tau_R$, et
dans laquelle la séquence de référence $R$ est disponible à l'avance et la séquence cible $S$ à construire n'est pas disponible à l'avance, mais est **caractérisée par** sa fréquence d'échantillonnage $f_S$ et sa phase initiale $\tau_S$, et
dans laquelle $f_S$, $f_R$, $\tau_S$ et $\tau_R$ sont utilisés pour calculer mathématiquement un vecteur de valeurs des indices d'échantillons dans la séquence de référence $R$, ces indices étant des indices limites qui sont utilisés pour délimiter des ensembles consécutifs d'échantillons dans la séquence de référence $R$,
dans laquelle la séquence cible $S$ est construite en prenant et plaçant lesdits ensembles consécutifs d'échantillons et en, à la transition entre lesdits ensembles, soit dupliquant soit supprimant au moins un échantillon de la séquence de référence $R$ avec l'indice limite correspondant ;
la séquence cible $S$ étant utilisée comme vecteur PRN échantillonné, destiné à être utilisé comme réplique pour une modulation à spectre étalé.

2. Le procédé selon la revendication 1, dans lequel la fréquence d'échantillonnage $f_R$ de la séquence de référence $R$ est un multiple entier du débit chip $f_C$, où $f_R = M_S \cdot f_C$, étant $M_S = round\left(\frac{f_S}{f_C}\right)$ et $M_S > 1$, avec $f_S$ étant la fréquence d'échantillonnage de la séquence cible,

dans lequel chaque ensemble d'échantillons de la séquence de référence *R* est délimité par des échantillons ayant des indices *i,* définis au sein de la séquence de référence, donnés par chaque couple de deux éléments consécutifs d'un premier vecteur $[m_k]$, avec $k = [0 ... (N_S - 1)]$, dans lequel le premier vecteur $[m_k]$ est défini comme suit :

• si

$$f_S > f_R:$$

$$N_S = ceil[f_S \cdot N_C \cdot M_S \cdot (T_R - T_S)],$$

$$[n_k] = \left[\frac{(k+1) \cdot T_R - (T_S - \tau_S)}{T_R - T_S} - k\right], \qquad [m_k] = floor([n_k]),$$

• si

$$f_S < f_R:$$

$$N_S = ceil[f_S \cdot N_C \cdot M_S \cdot (T_S - T_R)],$$

$$[n_k] = \left[\frac{(k+1) \cdot T_R - \tau_S}{T_S - T_R} + k\right], \quad [m_k] = ceil([n_k]),$$

où *floor* et *ceil* représentent l'arrondi entier vers -∞ et ∞, respectivement, et dans lequel la séquence cible *S* est calculée comme suit :

• si

$$f_S > f_R$$

$$S = \begin{bmatrix} r_{(0)} \cdots r_{(m_0)}, r_{(m_0)}, r_{(m_0+1)} \cdots r_{(m_1)}, r_{(m_1)}, r_{(m_1+1)} \cdots \\ , \cdots r_{\left(m_{(N_S-1)}\right)}, r_{\left(m_{(N_S-1)}\right)}, r_{\left(m_{(N_S-1)}+1\right)} \cdots r_{(L_R-1)} \end{bmatrix}$$

où les échantillons $r_{(mk)}$ avec les indices $i = m_k$ du premier vecteur $[m_k]$, lesdits échantillons définis au sein de la séquence de référence, sont dupliqués lors de la construction de la séquence cible,

• si

$$f_S < f_R:$$

$$S = \begin{bmatrix} r_{(0)}, \cdots, r_{(m_0-1)}, r_{(m_0+1)} \cdots r_{(m_1-1)}, r_{(m_1+1)}, \cdots \\ , \cdots r_{\left(m_{(N_S-1)}-1\right)}, r_{\left(m_{(N_S-1)}+1\right)}, \cdots, r_{(L_R-1)} \end{bmatrix}$$

où les échantillons de référence $r_{(mk)}$ avec les indices $i = m_k$ du premier vecteur $[m_k]$ sont supprimés lors de la construction de la séquence cible.

3. Le procédé selon la revendication 1, dans lequel la fréquence d'échantillonnage $f_S$ de la séquence cible *S* est un multiple entier du débit chip $f_C$, où $f_S = M_R \cdot f_C$, étant $M_R = round(\frac{f_R}{f_C})$ et $M_R > 1$, avec $f_R$ étant la fréquence d'échantillonnage de la séquence de référence,

dans lequel chaque ensemble d'échantillons de la séquence de référence $R$ est délimité par des échantillons ayant des indices $i$, définis au sein de la séquence de référence, donnés par chaque couple de deux éléments consécutifs d'un deuxième vecteur $[m'_e]$, avec $e = [0 \dots N_R - 1]$, dans lequel le deuxième vecteur $[m'_e]$ est défini comme suit :

• si

$$f_S < f_R:$$

$$N_R = ceil[f_R \cdot N_C \cdot M_R \cdot (T_S - T_R)],$$

$$[n'_e] = \left[ \frac{(e+1) \cdot T_S - (T_R - \tau_R)}{T_S - T_R} - 1 \right], \ [m'_e] = floor([n'_e])$$

• si

$$f_S > f_R:$$

$$N_R = ceil[f_R \cdot N_C \cdot M_R \cdot (T_R - T_S)]$$

$$[n'_e] = \left[ \frac{(e+1) \cdot T_S - \tau_R}{T_R - T_S} + 1 \right], \ [m'_e] = ceil([n'_e])$$

où *floor* et *ceil* représentent l'arrondi entier vers $-\infty$ et $\infty$, respectivement, et dans lequel la séquence cible S est calculée comme suit :

• si

$$f_S < f_R:$$

$$S = \begin{bmatrix} r_{(0)}, \ \dots, r_{(m'_0-1)}, r_{(m'_0+1)}, \ \dots, r_{(m'_1-1)}, r_{(m'_1+1)}, \ \dots \\ , \ \dots, r_{(m'_{(N_R-1)}-1)}, r_{(m'_{(N_R-1)}+1)}, \ \dots, r_{(L_R-1)} \end{bmatrix}$$

où les échantillons $r_{(m'_e)}$, avec les indices $i = m'_e$ du deuxième vecteur $[m'_e]$ sont supprimés lors de la construction de la séquence cible,

• si

$$f_S > f_R:$$

$$S = \begin{bmatrix} r_{(0)} \ \dots \ r_{(m'_0)}, r_{(m'_0-\Delta_0)}, r_{(m'_0+1)} \ \dots \ r_{(m'_1)}, r_{(m'_1-\Delta_1)}, r_{(m'_1+1)} \ \dots \\ \dots, r_{(m'_{(N_R-1)})}, r_{(m'_{(N_R-1)}-\Delta_{(N_R-1)})}, r_{(m'_{(N_R-1)}+1)}, r_{(L_R-1)} \end{bmatrix}$$

où les échantillons $r_{(m'_e)}$ avec les indices $i = m'_e$ du deuxième vecteur $[m'_e]$ sont dupliqués lors de la construction de la séquence cible,
et dans lequel $\Delta_e$ est :

*if*

$$modulus(m'_e, M_R) = 0 \Rightarrow \Delta_e = 1$$

*if*

$$modulus(m'_e, M_R) \neq 0 \Rightarrow \Delta_e = 0.$$

4. Le procédé selon la revendication 1, dans lequel chaque ensemble d'échantillons de la séquence de référence *R* est délimité par des échantillons ayant des indices donnés par chaque couple de deux éléments consécutifs d'un vecteur $[q_j]$, le vecteur $[q_j]$ étant calculé par arrondi des éléments d'un autre vecteur $[p_j]$ calculé en combinant des éléments d'un premier vecteur $[n_k]$ et des éléments d'un deuxième vecteur $[n'_e]$,

dans lequel le premier vecteur $[n_k]$ avec $k = [0 ... N_S - 1)]$ est défini pour la séquence cible S comme suit :

a) si

$$f_S > M_S \cdot f_C:$$

$$N_S = ceil[f_S \cdot N_C \cdot M_S \cdot (T'_S - T_S)], [n_k] = \left[\frac{(k+1) \cdot T'_S - (T_S - \tau_S)}{T'_S - T_S} - k\right],$$

b)

$$f_S < M_S \cdot f_C:$$

$$N_S = ceil[f_S \cdot N_C \cdot M_S \cdot (T_S - T'_S)], \quad [n_k] = \left[\frac{(k+1) \cdot T'_S - \tau_S}{T_S - T'_S} + k\right]$$

où $M_S$ est un nombre $M_S = round\left(\frac{f_S}{f_C}\right)$, $M_S > 1$, et $T'_S = \frac{1}{M_S \cdot f_C}$,

dans lequel le deuxième vecteur $[n'_e]$ avec $e = [0 ... (N_R - 1)]$ est défini pour la séquence de référence *R* comme suit :

c) si

$$f_R > M_R \cdot f_C:$$

$$N_R = ceil[f_R \cdot N_C \cdot M_R \cdot (T'_R - T_R)], \qquad [n'_e] = \left[\frac{(e+1) \cdot T'_R - (T_R - \tau_R)}{T'_R - T_R}\right]$$

d) si

$$f_R < M_R \cdot f_C:$$

$$N_R = ceil[f_R \cdot N_C \cdot M_R \cdot (T_R - T'_R)], [n'_e] = \left[\frac{(e+1) \cdot T'_R - \tau_R}{T_R - T'_R}\right]$$

où $M_R$ est un nombre $M_R = round\left(\frac{f_R}{f_C}\right)$, $M_R > 1$, et $T'_R = \frac{1}{M_R \cdot f_C}$,

dans lequel les éléments de $[p_j]$ sont triés par ordre croissant, où chaque élément $q_j$ est calculé par arrondi de l'élément correspondant $p_j$.

5. Le procédé selon la revendication 4, dans lequel chaque élément $q_j$ est calculé par arrondi de l'élément correspondant $p_j$ comme suit :

$$[q_j] = trunc[p_j + \alpha_j \cdot \delta_j]$$

où :

• *trunc* est l'arrondi vers -∞ si l'élément $p_j$ est lié à une séquence suivant l'un quelconque des cas a) ou c) ci-dessus, ou vers ∞ si l'élément $p_j$ est lié à une séquence suivant l'un quelconque des cas b) ou d) ci-dessus,
• $\delta_j$ et $\alpha_j$ sont deux nombres entiers, définis pour chaque indice $j$ comme suit :

  ◦ si la séquence de référence et la séquence cible sont dans les cas a) ou c), $\delta_j = 0$,
  o si la séquence de référence et la séquence cible sont dans les cas b) ou d), $\delta_j = 0$,
  o si la séquence de référence est dans les cas a) ou c) et la séquence cible est dans les cas b) ou d), $\delta_j$ est le nombre d'éléments dans le vecteur $[p_j]$ avec des indices inférieurs à $j$ correspondant à la séquence de référence et $\alpha_j = 1$,
  o si la séquence de référence est dans les cas b) ou d) et la séquence cible est dans les cas a) ou c), $\delta_j$ est le nombre d'éléments dans le vecteur $[p_j]$ avec des indices inférieurs à $j$ correspondant à la séquence cible et $\alpha_j = -1$, dans lequel la séquence cible est construite en concaténant les ensembles d'échantillons de la séquence de référence délimités par des couples consécutifs d'éléments du vecteur $[q_j]$, et où, pour chaque ensemble, au moins un échantillon est soit dupliqué si l'élément donné $q_j$ correspond à une séquence des cas a) ou c), soit supprimé si l'élément donné $q_j$ correspond à une séquence des cas b) ou d),

et où, lorsque pour un élément donné $q_j$, un échantillon de référence doit être dupliqué, l'indice de l'échantillon de référence à dupliquer est :

• $q_j$ si

$$modulus\left(q_j, M_R\right) \neq 0 ,$$

• $q_j$ - 1 si

$$modulus\left(q_j, M_R\right) = 0,$$

et où, lorsque pour un élément donné $q_j$, un échantillon de référence doit être supprimé, l'indice de l'échantillon de référence à supprimer est donné par l'élément $q_j$.

6. Le procédé selon l'une quelconque des revendications 2 à 3, dans lequel la séquence de référence et/ou la séquence cible sont/est conditionnée(s) en ensembles de mots, chaque mot étant composé de *N* bits,
dans lequel chaque élément du premier vecteur $[m_k]$ et/ou du deuxième vecteur $[m'_k]$ est représenté par un premier nombre et un deuxième nombre, le premier nombre correspondant à un indice de mot et le deuxième nombre indiquant un indice de bit au sein du mot correspondant.

7. Le procédé selon la revendication 4, dans lequel la séquence de référence et/ou la séquence cible sont/est conditionnée(s) en ensembles de mots, chaque mot étant composé de *N* bits,
dans lequel chaque élément du premier vecteur $[n_k]$ et du deuxième vecteur $[n'_e]$ est représenté par un premier nombre et un deuxième nombre, le premier nombre correspondant à un indice de mot et le deuxième nombre indiquant un indice de bit au sein du mot correspondant.

8. Le procédé selon l'une quelconque des revendications 6 à 7, dans lequel l'étape de duplication et/ou de suppression d'échantillons de la séquence de référence afin de construire la séquence cible, est réalisée en utilisant des opérations bit à bit.

9. Le procédé selon l'une quelconque des revendications 1 à 8, dans lequel la fréquence d'échantillonnage $f_R$ de la séquence de référence et/ou la fréquence d'échantillonnage $f_S$ de la séquence cible sont/est variable(s) dans le temps, et sont/est exprimée(s), pour un temps donné $t$, en termes de dérivées temporelles, $\dot{f}_x, \ddot{f}_x, \ldots$ de la fréquence d'échantillonnage correspondante $f_x$ avec $x = 1$ or 2, comme suit :

$$f_x(t) = f_{x,0} + \dot{f}_x \cdot t + \frac{1}{2} \cdot \ddot{f}_x \cdot t^2 + \cdots.$$

10. Dispositif de traitement de signal, comprenant :

   au moins un processeur ; et
   au moins une mémoire ;
   dans lequel l'au moins une mémoire est configurée, conjointement avec l'au moins un processeur, pour amener le dispositif de traitement de signal à exécuter les étapes d'un procédé selon l'une quelconque des revendications 1 à 9.

11. Le dispositif de traitement de signal selon la revendication 10, dans lequel le dispositif de traitement de signal est un récepteur GNSS.

12. Programme d'ordinateur comprenant des instructions qui, lorsque le programme est exécuté par un dispositif informatique, amènent le dispositif informatique à exécuter les étapes d'un procédé selon l'une quelconque des revendications 1 à 9.

FIG. 1

FIG. 2A

**FIG. 2B**

**EP 4 660 667 B1**

**Patent documents cited in the description**

- WO 9637789 A1